# EUROPEAN PATENT APPLICATION

(11) **EP 4 465 370 A1**
(43) Date of publication of application: **20.11.2024**
(21) Application number: 23740513.9
(22) Date of filing: 13.01.2023
(51) Int. Cl.: H01L 33/58, H01L 33/60, H01L 33/62, H01L 33/50, H01L 33/48

(54) **LIGHT-EMITTING PACKAGE**

(30) Priority: 13.01.2022 KR 20220005076; 12.01.2023 KR 20230004936
(71) Applicant: Seoul Semiconductor Co., Ltd., Gyeonggi-do 15429 (KR)
(72) Inventor: JANG, Bo Ram I, Ansan-si Gyeonggi-do 15429 (KR); PARK, Ki Yon, Ansan-si Gyeonggi-do 15429 (KR); SONG, Jae Wan, Ansan-si Gyeonggi-do 15429 (KR)
(74) Representative: Stolmár & Partner Patentanwälte PartG mbB
(86) International application number: PCT/KR2023/000686
(87) International publication number: WO 2023/136670

(57) **Abstract**

The present disclosure relates to a light emitting package. According to an embodiment of the present disclosure, a light emitting package including a substrate on which an circuit pattern is formed, a first optic portion, a light controller, and a second optic portion is provided. The first optic portion may be arranged on the substrate to be electrically connected to the circuit pattern, and may generate and emit light. The light controller may be formed to cover a side surface of the first optic portion, and may reflect light emitted from the side surface of the first optic portion. In addition, the second optic portion may cover the first optic portion and the light controller, and may be secured on the light controller. Herein, the second optic portion may include a securing region secured on the substrate and a light emitting region disposed over the securing region. Light emitted from the first optic portion may be emitted to the outside of the second optic portion through the second optic portion.

## Description

### [Technical Field]

The present disclosure relates to a light emitting package.

### [Background Art]

Light emitting diodes are inorganic light sources, and are used in various technical fields such as display devices, vehicle lamps, and general lighting. In particular, the light emitting diodes have a long lifespan and low power consumption, so they have been quickly replacing conventional lighting sources.

However, despite various advantages of light emitting diodes (LEDs), such as more excellent response, lower power consumption, longer lifespan than the conventional lighting sources, and environmental friendliness, they have been limitedly used as backlight light sources for small display devices due to their low luminance and low output.

Recently, they have been in the spotlight as a new lighting source as high-brightness and high-output light emitting diodes were developed.

Generally, a light emitting package of a lighting apparatus includes a light emitting diode, a phosphor layer covering the light emitting diode, and a lens. The phosphor layer excites some of light emitted from the light emitting diode to emit light in different wavelength ranges. In addition, the lens diffuses light emitted from the light emitting diode and the phosphor layer.

However, a conventional light emitting package has a drawback that a color of light passing through an upper surface of the lens and a color of light passing through a side surface of the lens may differ depending on a structure in which the phosphor layer surrounds the light emitting diode.

### [Disclosure]

### [Technical Problem]

Exemplary embodiments of the present disclosure are to apply a light emitting package with increased light intensity.

Exemplary embodiments of the present disclosure are to provide a light emitting package that is configured to emit light of a uniform color throughout an entire region of an optic portion.

### [Technical Solution]

According to an embodiment of the present disclosure, a light emitting package including a substrate on which an circuit pattern is formed, a first optic portion, a light controller, and a second optic portion is provided. The first optic portion may be arranged on the substrate to be electrically connected to the circuit pattern, and may generate and emit light. The light controller may be formed to cover a side surface of the first optic portion, and may reflect light emitted from the side surface of the first optic portion. In addition, the second optic portion may cover the first optic portion and the light controller, and may be secured on the light controller. Herein, the second optic portion may include a securing region secured on the substrate and a light emitting region disposed over the securing region. Light emitted from the first optic portion may be emitted to the outside of the second optic portion through the second optic portion.

### [Advantageous Effects]

A light emitting package according to an embodiment of the present disclosure may emit light of a uniform color throughout an entire region thereof.

In addition, the light emitting package according to an embodiment of the present disclosure may increase an amount of light using light emitted from a side surface as well as an upper surface of a light source.

### [Description of Drawings]

FIG. 1 is a perspective view of a light emitting package according to a first embodiment of the present disclosure.
FIG. 2 is a top plan view of the light emitting package according to the first embodiment of the present disclosure.
FIG. 3 is a cross-sectional view (A1-A2) of the light emitting package according to the first embodiment of FIG. 1.
FIG. 4 is another cross-sectional view (A3-A4) of the light emitting package according to the first embodiment of FIG. 1.
FIG. 5 is a bottom plan view of the light emitting package according to the first embodiment of the present disclosure.
FIG. 6 is a plan view of a light emitting package according to a second embodiment of the present disclosure.
FIG. 7 is a cross-sectional view (B1-B2) of the light emitting package according to the second embodiment of FIG. 6.
FIG. 8 is an exemplary diagram of a light emitting package according to a third embodiment of the present disclosure.
FIG. 9 is an exemplary diagram of a light emitting package according to a fourth embodiment of the present disclosure.
FIG. 10 is an exemplary diagram of a light emitting package according to a fifth embodiment of the present disclosure.
FIG. 11 is an exemplary diagram of a light emitting package according to a sixth embodiment of the present disclosure.
FIG. 12 is a plan view of a light emitting package according to a seventh embodiment of the present disclosure.
FIG. 13 is a cross-sectional view (C1-C2) of the light emitting package according to the seventh embodiment of FIG. 12.
FIG. 14 is a cross-sectional view of a light emitting package according to an eighth embodiment of the present disclosure.
FIG. 15 is a plan view of a light emitting package according to a ninth embodiment of the present disclosure.
FIG. 16 is a cross-sectional view (D1-D2) of the light emitting package according to the ninth embodiment of FIG. 15.
FIG. 17 is a plan view of a light emitting package according to a tenth embodiment of the present disclosure.
FIG. 18 is a cross-sectional view (E1-E2) of the light emitting package according to the tenth embodiment of FIG. 17.
FIG. 19 is a plan view of a light emitting package according to an 11th embodiment of the present disclosure.
FIG. 20 is a cross-sectional view (F1-F2) of the light emitting package according to the 11th embodiment of FIG. 19.
FIG. 21 is an exemplary diagram of a light emitting package according to a 12th embodiment of the present disclosure.
FIG. 22 is an exemplary diagram of a light emitting package according to a 13th embodiment of the present disclosure.
FIG. 23 is an exemplary diagram of a light emitting package according to a 14th embodiment of the present disclosure.
FIG. 24 is an exemplary diagram of a light emitting package according to a 15th embodiment of the present disclosure.
FIG. 25 is an exemplary diagram of a light emitting package according to a 16th embodiment of the present disclosure.
FIG. 26 is a perspective view of a light emitting package according to a 17th embodiment of the present disclosure.
FIG. 27 is a cross-sectional view (G1-G2) of the light emitting package according to the 17th embodiment of the present disclosure.
FIG. 28 is a plan view of the light emitting package according to the 17th embodiment of the present disclosure.
FIG. 29 is a plan view of a light emitting package according to an 18th embodiment of the present disclosure.
FIG. 30 is a cross-sectional view (I1-I2) of the light emitting package according to the 18th embodiment of the present disclosure.
FIG. 31 is a plan view of the light emitting package according to the 18th embodiment of the present disclosure.

### [Best Mode]

Hereinafter, exemplary embodiments of the present disclosure will be described in detail with reference to the accompanying drawings. The following exemplary embodiments are provided by way of example so as to fully convey the spirit of the present disclosure to those skilled in the art to which the present disclosure pertains. Accordingly, the present disclosure is not limited to the embodiments disclosed herein and can also be implemented in different forms. In addition, in the drawings, widths, lengths, thicknesses, and the like of elements can be exaggerated for clarity and descriptive purposes. Throughout the specification, like reference numbers denote like elements having the same and similar reference numbers denote corresponding similar elements.

A light emitting package according to an embodiment of the present disclosure may include a substrate on which an circuit pattern is formed, a first optic portion, a light controller, and a second optic portion. The first optic portion may be arranged on the substrate to be electrically connected to the circuit pattern, and may generate and emit light. The light controller may be formed to cover a side surface of the first optic portion, and may reflect light emitted from the side surface of the first optic portion. In addition, the second optic portion may cover the first optic portion and the light controller, and may be secured on the light controller. Herein, the second optic portion may include a securing region secured on the substrate and a light emitting region disposed over the securing region. Light emitted from the first optic portion may be emitted to the outside of the second optic portion through the second optic portion.

According to this embodiment, the first optic portion may include a light generator, an optical characteristic converter, and a connection pad. The light generator may generate light and emit first light from at least a side surface or an upper surface thereof. The optical characteristic converter may be formed over the light generator, and may emit the first light and second light from a side surface and an upper surface thereof. In addition, the connection pad may be formed under the light generator, and may be connected to the circuit pattern of the substrate. Herein, the optical characteristic converter may convert optical characteristics of some of the first light into optical characteristics of the second light.

For example, the optical characteristic converter may convert a wavelength band of some of the first light into a wavelength band of the second light.

The light generator may include a first semiconductor layer doped with an n-type dopant, a second semiconductor layer doped with a p-type dopant, and an active layer formed between the first semiconductor layer and the second semiconductor layer.

The light generator may further include a growth substrate on which the first semiconductor layer or the second semiconductor layer is grown, and arranged under the optical characteristic converter.

The light controller may be formed such that at least a region of a bottom edge thereof is disposed inside a region below the light emitting region of the second optic portion.

A corner of the bottom edge of the light controller may have a curved shape.

According to another embodiment, the light emitting package may further include a separation layer formed under the optical characteristic converter. The separation layer may be formed along a side surface of the light generator between the light generator and the light controller, and may be formed to cover at least a region of the side surface of the light generator.

The first light emitted from the side surface of the light generator may be reflected on an inner surface of the light controller through the separation layer. First light reflected from the inner surface of the light controller may incident on the optical characteristic converter disposed over the separation layer.

For example, the separation layer may be formed to cover entire side surfaces of the light generator.

In addition, the separation layer may be formed such that a bottom thereof is disposed at a midpoint between a top and a bottom of the light generator or under the midpoint.

For example, the separation layer may be formed such that a thickness thereof at the side surface of the light generator gradually decreases from the top to the bottom of the light generator.

In addition, the separation layer may be formed such that the thickness thereof at the side surface of the light generator gradually increases from the top to the bottom of the light generator.

The light emitting region may have a structure in which a height of the light emitting region is larger than a bottom diameter of the light emitting region.

At least a region of the securing region may be in contact with an upper surface of the substrate.

According to another embodiment, the first optic portion may include a plurality of light generators arranged to be spaced apart from one another. Herein, the optical characteristic converter may be formed to cover the plurality of light generators.

According to another embodiment, the light emitting package may be provided with a plurality of the first optic portions. The plurality of first optic portions may be arranged to be spaced apart from one another. In addition, the light controller may be formed between the plurality of first optic portions.

The light controller may include a silicone resin and titanium oxide (TiO₂) dispersed in the silicone resin.

In addition, the separation layer may be formed of a silicone resin through which light transmits.

According to another embodiment, the substrate may further include a heat dissipation pad formed on a surface opposite to one surface of the substrate on which the first optic portion is disposed. The heat dissipation pad may be disposed under the first optic portion and the circuit pattern formed on one surface of the substrate. In this case, both ends of the heat dissipation pad, both ends of the connection pad, and both ends of the circuit pattern formed on one surface of the substrate may be arranged on different positions from one another with respect to a perpendicular line.

Hereinafter, embodiments of the light emitting package of the present disclosure will be described in detail with the accompanying drawings.

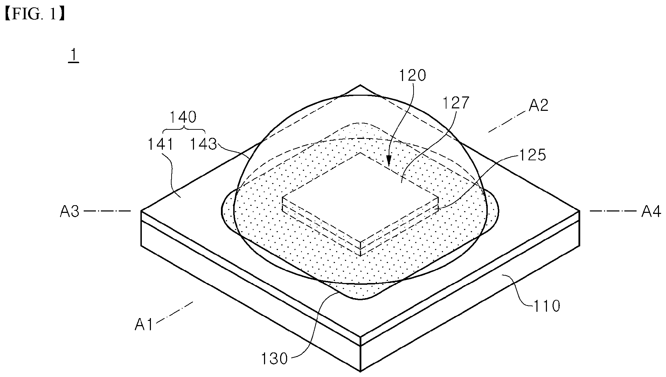

FIG. 1 through FIG. 5 are exemplary diagrams of a light emitting package according to a first embodiment of the present disclosure.

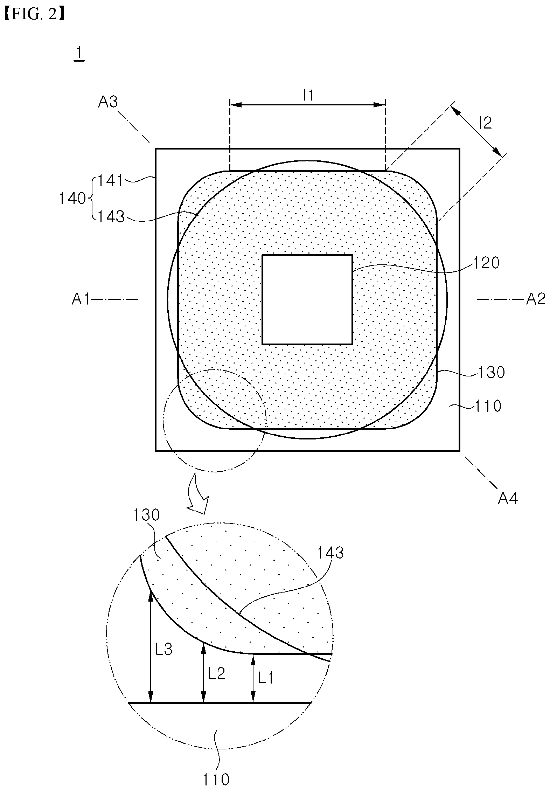

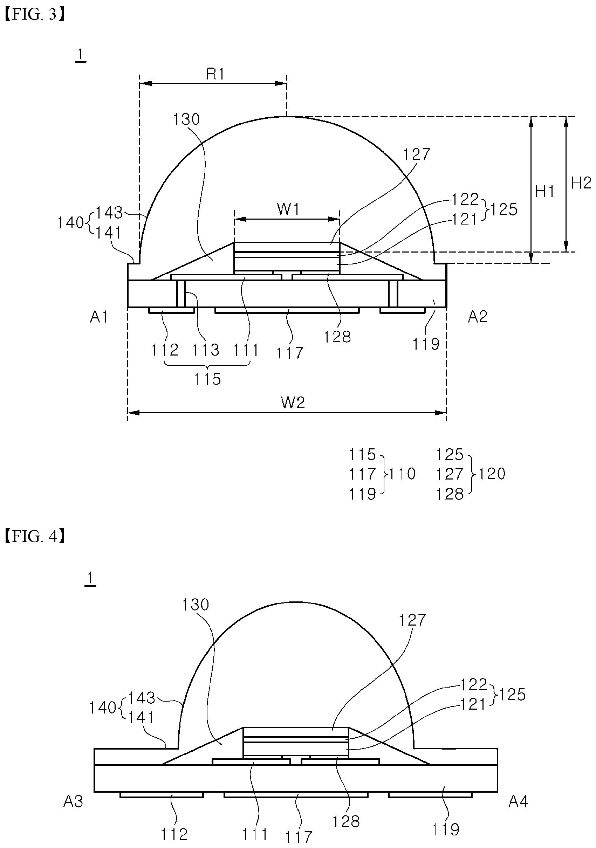

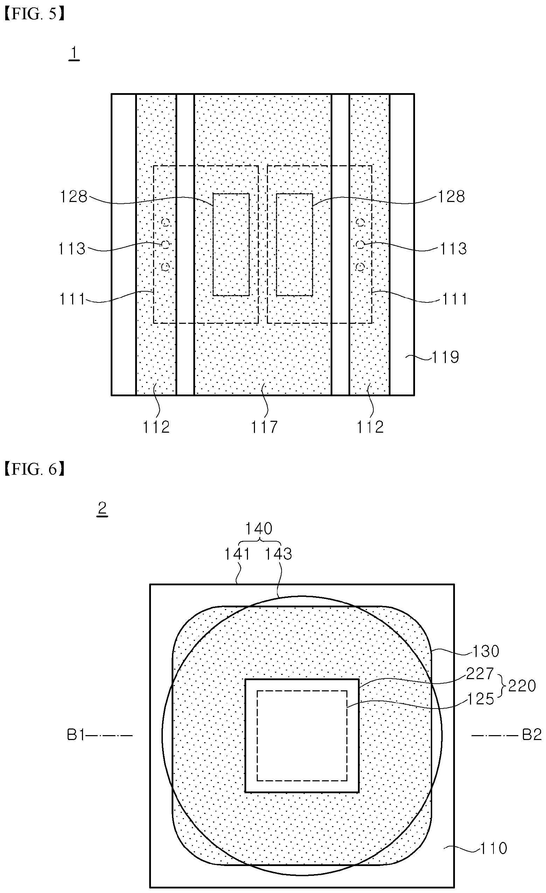

FIG. 1 is a perspective view of a light emitting package according to a first embodiment of the present disclosure. FIG. 2 is a top plan view of a light emitting package 1 according to the first embodiment of the present disclosure. FIG. 3 is a cross-sectional view (A1-A2) of the light emitting package 1 according to the first embodiment of FIG. 1. FIG. 4 is another cross-sectional view (A3-A4) of the light emitting package 1 according to the first embodiment of FIG. 1. In addition, FIG. 5 is a bottom plan view of the light emitting package 1 according to the first embodiment of the present disclosure.

The light emitting package 1 according to the first embodiment may include a substrate 110, a first optic portion 120, a second optic portion 140, and a light controller 130.

The first optic portion 120 may include a light generator 125, a connection pad 128, and an optical characteristic converter 127. The light generator 125 may include a first light generation region 121 and a second light generation region 122.

The first light generation region 121 receives power and generates first light. For example, the first light generation region 121 may include a first semiconductor layer, a second semiconductor layer, and an active layer.

The first semiconductor layer may be formed of a compound semiconductor such as group III-V, group II-VI, or the like. For example, the first semiconductor layer may be an n-type semiconductor layer doped with an n-type dopant.

The second semiconductor layer may be formed of a compound semiconductor such as group III-V, group II-VI, or the like. For example, the second semiconductor layer may be a p-type semiconductor layer doped with a p-type dopant.

Herein, although it has been described that the first semiconductor layer is the n-type semiconductor layer and the second semiconductor layer is the p-type semiconductor layer, but on the contrary, the first semiconductor layer may be a p-type semiconductor layer and the second semiconductor layer may be an n-type semiconductor layer.

The active layer may be formed between the first semiconductor layer and the second semiconductor layer.

The active layer is a layer where electrons injected through the first semiconductor layer and holes injected through the second semiconductor layer recombine, and light may be generated through a recombination of electrons and holes. Alternatively, the active layer may generate light through the recombination of holes injected through the first semiconductor layer and electrons injected through the second semiconductor layer.

The active layer may be formed in any one of a single well structure, a multi-well structure, a single quantum well structure, a multi quantum well (MQW) structure, a quantum dot structure, or a quantum wire structure.

Light generated in the active layer may be emitted to the outside of the first light generation region 121 through a side surface and an upper surface of the first light generation region 121. In addition, light generated in the active layer may be emitted to the outside of the first light generation region 121 through a lower region of the first light generation region 121.

A type of light generated may vary depending on a type of composition forming the first semiconductor layer, the second semiconductor layer, and the active layer. For example, the first light generation region 121 may generate and emit blue light or ultraviolet light. The type of light emitted from the first light generation region 121 is not limited to blue light and ultraviolet light, and may emit light in various wavelength ranges.

Referring to FIG. 3, the second light generation region 122 may be formed over the first light generation region 121.

The second light generation region 122 may emit first light incident through the upper surface of the first light generation region 121 to the outside of the second light generation region 122 through a side surface and an upper surface thereof.

The second light generation region 122 may be formed of a material that is used to form the first light generation region 121. That is, the second light generation region 122 may be a growth substrate for growing a semiconductor layer. For example, the second light generation region 122 may be formed of a material selected from sapphire (Al₂O₃), SiC, GaAs, GaN, ZnO, Si, GaP, InP, and Ge.

Accordingly, first light generated by the first light generation region 121 may be emitted from the surfaces of the first light generation region 121 and the second light generation region 122.

The connection pad 128 may electrically connect the first optic portion 120 and the substrate 110.

The connection pad 128 may be electrically connected to a circuit pattern 115 of the substrate 110. Referring to FIGs. 3 and 4, the connection pad 128 may be electrically connected to the circuit pattern 115 by directly contacting the circuit pattern 115. Alternatively, the connection pad 128 may be electrically connected to the circuit pattern 115 through a conductive material having an adhesion.

One of two connection pads 128 may be electrically connected to the first semiconductor layer of the first light generation region 121, and another may be electrically connected to the second semiconductor layer of the first light generation region 121.

The first optic portion 120 may generate first light using power supplied through the connection pad 128.

Referring to FIGs. 3 and 4, the optical characteristic converter 127 may be formed over the light generator 125.

The optical characteristic converter 127 may change characteristics of first light generated by the first light generation region 121.

First light emitted through an upper surface of the light generator 125 may pass through the optical characteristic converter 127. In this case, a portion of first light incident into the optical characteristic converter 127 may have a wavelength band converted within the optical characteristic converter 127.

Accordingly, the optical characteristic converter 127 may emit first light generated by the light generator 125 and second light of which the wavelength band is converted within the optical characteristic converter 127.

The optical characteristic converter 127 may include a transparent resin formed of a light-transmitting material and an optical characteristic conversion material dispersed within the transparent resin. The optical characteristic conversion material may be any material that can convert the wavelength of light. For example, the optical characteristic conversion material may be formed of at least one material of a phosphor or a quantum dot. In addition, phosphors of various structures may be dispersed in the transparent resin. A structure of the phosphor may also vary depending on a type of phosphor. Some of the phosphors dispersed in the transparent resin may be a phosphor with a rod structure having a long length or a phosphor with an irregular structure.

In an embodiment of the present disclosure, the phosphor may include at least a phosphor of a green phosphor, a yellow phosphor, a red phosphor, or a cyan phosphor.

For example, the phosphor may be a garnet-based phosphor represented by (A, B, C)₈₋ₓO₁₂:Ce. Herein, A may include at least an element of Y, Lu, Tb, Gd, La, or Sm. C may include at least an element of Al, Si, Ga, or In. B may be either an element of A or B. Alternatively, B may be a same element as A or B. In this case, when B is one of the elements of C, a sum of moles of B and C may be greater than 5 and less than 7. In addition, when B is one of the elements of A, a sum of moles of A and B may be greater than 1 and less than 5. In addition, X may be greater than 0.001 and less than or equal to 0.5.

The phosphor may include at least a garnet-based phosphor, a silicate-based phosphor, a sulfide-based phosphor, an oxynitride-based phosphor, a nitride-based phosphor, or an aluminates-based phosphor.

For example, the garnet-based phosphor may be represented by a formula A₃B₅O₁₂:C. Herein, A may include at least an element of Y, Lu, Tb, or Gd. B may include at least an element of Al, Ga, Si, or In. In addition, C may include at least an element of Ce, Nd, Er, or Th. For example, the garnet-based phosphor may include a yellow phosphor of Y₃Al₅O₁₂:Ce(YAG:Ce), a yellow phosphor of Tb₃Al₅O₁₂:Ce(TAG:Ce), or a green phosphor of Lu₃Al₅O₁₂:Ce, or the like. In this case, the YAG phosphor may emit red light by replacing a part of Y with Gd, with a peak wavelength thereof shifting toward a red wavelength region. In addition, when a part of Al is replaced with Ga, a peak wavelength thereof shifts toward a green wavelength region, and thus, green light may be emitted. As such, the phosphor may control its emission color by adjusting a composition ratio of the elements.

In addition, the silicate-based phosphor may include a green or yellow phosphor of (Ba, Sr, Ca)₂SiO₄:Eu, a green or yellow phosphor of (Sr, Ba, Ca, Mg, Zn)₂Si(OD)₄:Eu (D is at least an element of F, Cl, S, N, or Br), a green phosphor of Ba₂MgSi₃O₇:Eu, a green phosphor of Ba₂SiO₄:Eu, a green phosphor of Ca₃(Sc,Mg)₂Si₃O₁₂:Ce, a green phosphor of Ca₈Mg(SiO₄)₄Cl₂:Eu, or the like.

In addition, the sulfide-based phosphor may include a red phosphor of (Ca, Sr)S:Eu, a green phosphor of (Sr,Ca)Ga₂S₄:Eu, a green phosphor of SrSi₂O₂N₂:Eu, or the like.

In addition, the oxynitride-based phosphor may include a blue or green phosphor of SiAlON:Ce, a green or yellow phosphor of β-SiAlON:Eu (e.g., Si_{6-z}Al_{z}O_{z}N_{8-z}:Eu (0<z<4.2)), an orange or yellow phosphor of α-SiAlON:Eu (e.g., M_{z}(Si, Al)₁₂(O, N)₁₆, 0<z≤2, M is a lanthanide element excluding Li, Mg, Ca, Y and La and Ce), a green phosphor of Ba₃Si₆O₁₂N₂:Eu, or the like.

In addition, the nitride-based phosphor may include a red phosphor of CaAlSiN₃:Eu, a yellow or red phosphor of (Sr,Ca)AlSiN₃:Eu, a red phosphor of Sr₂Si₅N₈:Eu, or the like.

In addition, the aluminate-based phosphor may include a blue phosphor of(Sr,Ba)Al₂O₄:Eu, a blue phosphor of (Mg,Sr)Al₂O₄:Eu, a blue phosphor of BaMg₂Al₁₆O₂₇:Eu, or the like.

In addition, the phosphor may include a fluoride phosphor.

For example, the fluoride phosphor may include a phosphor represented by A₂SiF₆:Mn. Herein, A may be an alkali metal element containing at least potassium. For example, the fluoride phosphor may be a red phosphor of K₂SiF₆:Mn.

In addition, the phosphor may include a fluoride phosphor containing manganese of A₂[M₁₋ₐMnₐF₆]. Herein, A may be at least a type selected from a group consisting of K, Li, Na, Rb, Cs or NH₄. M may be at least an element selected from a group consisting of group IV elements and group XIVelements. a may be 0<a<0.2.

The fluoride phosphor containing manganese (referred to as KSF phosphor) is doped with tetravalent manganese ions, and may emit red light in a region of about 630 nm. In addition, the fluoride phosphor containing manganese has two peak wavelengths representing colors, and accordingly, has an advantage of high color gamut rate.

In addition, the phosphor containing manganese may include a red phosphor represented by (A₄₋ₐBₐ)_{m/2+n/2}X₂ₘ[MX₄O₂]ₙ based on an oxidohalide host lattice. Herein, A may be selected from a group consisting of hydrogen (H), deuterium (D), or mixtures thereof. B may be selected from a group consisting of Li, Na, K, Rb, Cs,NH₄, ND₄, NR₄ or mixtures of two or more thereof. R may be an alkyl or aryl radical. X may be selected from a group consisting of F, Cl, or mixtures thereof. M may be selected from a group consisting of Cr, Mo, W, Re, or mixtures of two or more thereof. It may be 0≤a≤4, 0<m≤10, and 1≤n≤10.

In addition, the phosphor may include a cyan phosphor. The cyan phosphor may include at least one material of a LuAG material or a silicate material. Reliability may be improved when the cyan phosphor includes both LuAG material and silicate material. In addition, the cyan phosphor may further include neodymium oxide. Neodymium oxide may improve a color purity of light emitted from the cyan phosphor by absorbing at least a portion of light in a wavelength range of about 550 nm or less.

When the phosphor is formed by sintering with an addition of a sintering aid such as SiO₂, Al₂O₃, or the like, the phosphor may have improved fluorescence characteristics.

When the optical characteristic converter 127 includes quantum dots, the transparent resin may be possible in either a sheet form or a resin form. The quantum dots may include Cd and Se when they are formed of group II to VIcompounds. In addition, the quantum dots may include In and P when they are formed of group III to V compounds.

The quantum dots may include a core containing the group II to VIcompounds or the group III to V compounds and a protection layer surrounding the core to protect the core. Herein, the protection layer may include a shell and a ligand. In addition, the protection layer may include Zn, S, or the like.

In the quantum dots, light emission may occur in the core. As the quantum dot gets smaller, its band gap increases, and thus, it may emit light of shorter wavelengths. In addition, as the quantum dot increases in size, its band gap decreases, and thus, it may emit light of longer wavelengths. That is, as the size of the quantum dot decreases, the wavelength of light becomes shorter, and as the size increases, the wavelength of light becomes longer. As such, the wavelength of emitted light may be determined depending on a size of the core or the size of the quantum dot. For example, a diameter of the quantum dot or the core may be about 10 nm or less, and preferably about 2 nm to 5 nm.

In this embodiment, the light generator 125 of the first optic portion 120 includes both the first light generation region 121 and the second light generation region 122. However, the second light generation region 122 may be omitted, and the light generator 125 may be formed of only the first light generation region 121. In this case, the optical characteristic converter 127 is formed on the upper surface of the first light generation region 121.

The light emitting package 1 may emit a mixture of first light and second light emitted through the first optic portion 120 to the outside.

The light controller 130 is formed over the substrate 110 to cover a side surface of the first optic portion 120. As shown in FIG. 2, the light controller 130 may be formed to cover all side surfaces of the first optic portion 120.

The light controller 130 may control a proceeding direction of light emitted from the first optic portion 120.

The light controller 130 may prevent light emitted from the side surface of the first optic portion 120 from proceeding in a side surface direction.

In addition, the light controller 130 reflects light emitted from the side surface of the first optic portion 120. The light controller 130 may include a material that reflects light. The light controller 130 may be formed of an insulating material with a light reflection material dispersed therein. Alternatively, the light controller 130 may be formed of an insulating material of which the surface is coated with a light reflecting material. For example, the light controller 130 may be formed of silicone resin with titanium oxide (TiO₂) dispersed therein. In addition, the silicone resin forming the light controller 130 may be a methyl-based silicone resin.

In this embodiment, the optical characteristic converter 127 is formed on the upper surface of the light generator 125. Accordingly, ratios of first light and second light are different in an upper surface and the side surface of the first optic portion 120. That is, the ratio of first light to second light is higher on the side surface than on the upper surface of the first optic portion 120.

For example, first light may be blue light, and second light may be yellow light. In this case, white light may be emitted from the upper surface of the first optic portion 120, and light mixed with more blue light than white light emitted from the upper surface may be emitted from the side surface.

Alternatively, the optical characteristic converter 127 may be formed to generally cover the upper surface and the side surface of the light generator 125. In this case, when a thickness of the optical characteristic converter 127 formed on the upper surface of the light generator 125 is different from that of the optical characteristic converter 127 formed on the side surface of the light generator 125, colors of light emitted from the upper surface and the side surface of the first optic portion 120 may be different.

The light controller 130 in an embodiment of the present disclosure is formed to cover the side surfaces of the first optic portion 120, and thus, a light exiting surface of the first optic portion 120 may be limited to the upper surface of the optical characteristic converter 127. That is, the light controller 130 may guide a movement of light such that light generated in the first optic portion 120 is emitted only from the upper surface of the first optic portion 120.

In addition, the light controller 130 prevents light from being emitted to the outside of the first optic portion 120 from the side surface of the first optic portion 120, and thus, light of different colors may be prevented from being emitted from the upper surface and the side surface of the first optic portion 120. Accordingly, the light controller 130 may allow light of a uniform color to be emitted from an entire light exiting surface of the first optic portion 120.

In addition, the light controller 130 reflects light emitted from the side surface of the first optic portion 120. Light reflected from the light controller 130 may be directed to the upper surface of the first optic portion 120. Accordingly, since the light controller 130 may use light emitted from not only the upper surface but also the side surface of the first optic portion 120, a light amount of the light emitting package 1 may be increased.

The light controller 130 may be formed to have an edge structure having different curvatures.

Referring to FIG. 2, an edge of the light controller 130 includes a first edge I1 and a second edge I2 having different curvatures. The second edge I2 is a corner connecting the first edges I1 formed in different directions.

Accordingly, the edge of the light controller 130 has a structure in which the first edges I1 and the second edges I2 are alternately arranged in a clockwise or counterclockwise direction. That is, the light controller 130 may include a structure in which the edges having different curvatures are alternately arranged.

Based on the plan view of FIG. 2, the light controller 130 has a structure in which distances L1, L2, and L3 from an edge of an adjacent substrate 110 increase as a corner thereof is closer to a side surface of the substrate 110 from a center thereof. That is, L1 < L2 < L3.

That is, the light controller 130 has a structure in which corners of a bottom edge are curved, as shown in FIG. 2.

When the corner of the light controller 130 is formed sharp, stress such as heat or stress, may be concentrated on the sharp corner portion. In this case, cracks may occur at the sharp corner of the light controller 130.

In this embodiment, the corner of the light controller 130 is formed to have a curved structure such that stress is distributed rather than concentrated in one region. Accordingly, the light controller 130 of this embodiment may prevent stress from being concentrated at the corners thereof, thereby preventing the cracks from occurring at the corners.

Referring to FIGs. 3 and 4, the light controller 130 may have a structure with a flat outer surface. In addition, the light controllers 130 formed on both sides of the first optic portion 120 may have a symmetrical structure with respect to the first optic portion 120. However, the structure of the light controller 130 is not limited to the structure that the outer surface of the light controller 130 is flat and has the symmetrical structure with respect to the first optic portion 120. The light controller 130 may be formed in various structures covering the side surface of the first optic portion 120.

In addition, the light controller 130 may be formed to cover an upper surface and a side surface of an upper pattern 111. As such, when the light controller 130 is formed large enough to bury the upper pattern 111, a thickness from the side surface to an end of the first optic portion 120 is thick, and thus, light reflection efficiency may be improved. In addition, since the light controller 130 covers the upper pattern 111, it may prevent the upper pattern 111 from being exposed to light and deteriorated

The second optic portion 140 is formed on the substrate 110 to cover the first optic portion 120 and the light controller 130. The second optic portion 140 may include a light emitting region 143 and a securing region 141. In this embodiment, the second optic portion 140 may be formed in a structure including a curved surface.

The second optic portion 140 may be formed of a material that transmits light from the first optic portion 120. For example, the second optic portion 140 may be formed of silicone resin. For example, the second optic portion 140 may be formed of phenyl-based silicone resin.

According to this embodiment, the second optic portion 140 is disposed outside the light controller 130. That is, the phenyl-based silicone resin forming the second optic portion 140 is disposed outside the methyl-based silicone resin forming the light controller 130. Herein, the phenyl-based silicone resin has a refractive index of about 1.5, and the phenyl-based silicone resin has a refractive index of about 1.4. Accordingly, the phenyl-based silicone resin which has a higher refractive index than that of the methyl-based silicone resin is disposed outside the methyl-based silicone resin. In addition, the methyl-based silicone resin has higher reliability against heat, external impact, and the like, compared to the phenyl-based silicone resin. Accordingly, the methyl-based silicone resin may more effectively prevent the cracks due to external factors than the phenyl-based silicone resin. Accordingly, the light controller 130 formed including the methyl-based silicone resin may prevent the cracks due to the external factors from occurring, thereby improving the reliability. In addition, by including the methyl-based silicone resin, the light controller 130 may reduce an occurrence of cracks, preventing the light reflection efficiency from being reduced due to the cracks, thereby improving light reflection efficiency.

An inner surface of the second optic portion 170 may be formed to be spaced apart from the first optic portion 120. That is, a space may be formed between the second optic portion 170 and the first optic portion 120. In this case, the space between the second optic portion 170 and the first optic portion 120 may be filled with air or a light-transmissive material.

Alternatively, the inner surface of the second optic portion 170 may be formed to be in close contact with the first optic portion 120.

In addition, in another embodiment, the second optic portion 140 or the light-transmissive material filling the space between the second optic portion 140 and the first optic portion 120 may further include an optical characteristic conversion material capable of converting a wavelength range of light. In this case, the optical characteristic conversion material of the second optic portion 140 or the space between the second optic portion 140 and the first optic portion 120 may be a type different from the optical characteristic conversion material of the optical characteristic converter 127. For example, the optical characteristic conversion material of the second optic portion 140 or the space between the second optic portion 140 and the first optic portion 120 and that of the characteristic converter 127 may convert light into light of different wavelength ranges from each other. In this case, when a plurality of optical characteristic conversion materials that convert light into different characteristics is included, a CIE and a CRI of the light emitting package may be improved.

Light emitted from the first optic portion 120 may be emitted to the outside of the light emitting package 1 through the second optic portion 140.

The light emitting region 143 is disposed over the securing region 141.

In this embodiment, the light emitting region 143 may have a structure including a curved surface. For example, the light emitting region 143 may be formed in a hemispherical shape. However, the structure of the light emitting region 143 is not limited to the hemispherical shape. The light emitting region 143 may include one type of curved surface, or may include various types of curved surfaces.

The light exiting surface of the first optic portion 120 is disposed inside the light emitting region 143. Accordingly, the light exiting surface of the first optic portion 120 faces an inner side surface of the light emitting region 143, and light emitted from the first optic portion 120 may be emitted to the outside through the light emitting region 143. That is, a light exiting surface that emits light from the light emitting package 1 to the outside of the package 1 is the second optic portion 140 or the light emitting region 143 of the second optic portion 140.

In this embodiment, a height H1 of the light emitting region 143 may be equal to or greater than a bottom radius R1 of the light emitting region 143. Herein, the height H1 of the light emitting region 143 is a distance from a bottom to a top of the light emitting region 143. In addition, the bottom of the light emitting region 143 is an edge that meets the securing region 141 of the second optic portion 140. That is, the bottom radius R1 of the light emitting region 143 is a radius of a circular edge formed by the bottom of the light emitting region 143.

Alternatively, the light emitting package 1 may be formed to have a structure such that a distance H2 from the light generator 122 to a top of the second optic portion 140 is greater than a width W1 of the optical characteristic converter 127. Herein, the width W1 of the optical characteristic converter 127 may be a longest width of the optical characteristic converter 127. In this embodiment, the width W1 of the optical characteristic converter 127 is same as that of the light generator 125. However, structural features of the second optic portion 140 may be equally applied to an embodiment including an optical characteristic converter having a larger width than a light generator which will be described later.

As a size of the hemispherical light emitting region 143 increases, a light efficiency of the light emitting package 1 may increase. That is, as an area of an inner surface of the light emitting region 143, and a distance between the light exiting surface of the first optic portion 120 and the inner surface of the light emitting region 143 increase, the light efficiency of the light emitting package 1 may be improved.

However, when a diameter of the light emitting region 143 is increased larger than a length of the substrate 110 to increase the size of the hemispherical light emitting region 143, during a cutting process to individualize a plurality of packages 1 into a singularized package 1, a region of a side surface of the light emitting region 143 may be cut. Accordingly, the second optic portion 140 may be damaged or a light efficiency set according to a designed structure change may not be realized.

Accordingly, to prevent the above-mentioned drawback, a diameter of the bottom of the light emitting region 143 which has a largest diameter has to be smaller than a transverse or vertical length of the substrate 110.

In this embodiment, by forming the height of light emitting region 143 greater than the bottom radius, it is possible to increase an area of the light emitting region 143 while maintaining the hemispherical structure.

In addition, in the light emitting package 1 of this embodiment, the distance H2 from the upper surface of the light generator 125 to the top of the second optic portion 140 is greater than or equal to the width W1 of the optical characteristic converter 127, and less than or equal to the width W2 of the substrate 100 or the securing region 141 of the second optic portion 140. (W1≤H2≤W2)

The securing region 141 secures the second optic portion 140 to an optic package 1.

The securing region 141 is disposed under the light emitting region 143 and is in contact with the substrate 110. In addition, the securing region 141 may protrude outward from the light emitting region 143 and be formed to cover the edge of the substrate 110.

In addition, the securing region 141 may increase a separation distance between the light exiting surface of the first optic portion 120 and the light emitting region 143. That is, a distance between the light exiting surface of the first optic portion 120 and the inner surface of the light emitting region 143 on which light of the first optic portion 120 is incident may be increased by a height of the securing region 141.

In the light emitting package 1 according to this embodiment, the distance between the first optic portion 120 and the inner surface of the light emitting region 143 is increased by the securing region 141, and a distance over which light spreads within the light emitting region 143 is increased, and thus, the light efficiency may be improved.

When the second optic portion 140 and the light controller 130 are formed of the methyl-based silicone resin, the surfaces thereof are stabilized through a heat curing process, thereby reducing adhesion.

When the light controller 130 is formed to cover an entire substrate 110, the second optic portion 140 is bonded to the light controller 130 and secured to the package 1. That is, the surface thereof is stabilized, and thus, the light controller 130 and the second optic portion 140 which have low adhesion are in contact with each other.

In this case, when thermal or physical impact is applied to the package 1 due to the low adhesion between the second optic portion 140 and the light controller 130, the second optic portion 140 may be easily separated from the light controller 130.

To prevent this, the light controller 130 is formed not to cover the entire substrate 110. That is, the light controller 130 is formed to be disposed inside the securing region 141 of the second optic portion 140. Accordingly, the second optic portion 140 may contact the substrate 110 exposed to the outside of the light controller 130, and be secured on the substrate 110.

In addition, at least a region of the light controller 130 may be disposed inside the light emitting region 143 of the second optic portion 140. Accordingly, a contact area between the second optic portion 140 and the substrate 110 may be increased.

Referring to FIG. 2, the edges of the light emitting region 143 are alternately disposed inside and outside a region above the light controller 130 along an edge of the light emitting package 1. Through FIG. 3, a cross-section of a region where the edge of the light emitting region 143 is disposed in the outer a region above the light controller 130 can be seen. In addition, through FIG. 4, a cross section of a region where the edge of the light emitting region 143 is disposed in the inner a region above the light controller 130 can be seen.

When a distance from the side surface of the first optic portion 120 to the bottom edge of the light controller 130 is reduced to increase the contact area between the second optic portion 140 and the substrate 110, a thickness of the light controller 130 on the side surface of the first optic portion 120 may become smaller. In this case, the light controller 130 may not sufficiently reflect light emitted from the side surface of the first optic portion 120.

Accordingly, the light emitting package 1 of this embodiment may maintain the thickness of the light controller 130 that allows the light controller 130 to sufficiently reflect light emitted from the side surface of the first optic portion, and may maintain a sufficient contact force between the second optic portion 140 and the substrate 110.

As such, the light emitting package 1 according to this embodiment may reduce a contact area between the second optic portion 140 and the light controller 130 which have the low adhesion, and may increase the contact area between the second optic portion 140 and the substrate 110. Accordingly, the light emitting package 1 according to this embodiment may improve the adhesion between the second optic portion 140 and the substrate 110, thereby preventing the second optic portion 140 from being separated from the package 1 due to the external impact.

Referring to FIG. 3, the substrate 110 may include a support member 119, a circuit pattern 115, and a heat dissipation pad 117.

The support member 119 may support components disposed on the substrate 110, the circuit pattern 115, and the heat dissipation pad 117 formed on the substrate 110.

The support member 119 may be formed of an insulating material. For example, the support member 119 may be an insulation substrate 110 formed of epoxy resin or ceramic. Alternatively, the support member 119 may be a metallic substrate 110 with an oxide film formed on its surface.

The circuit pattern 115 plays a role to perform an electrical connection between internal components of the light emitting package 1 and external components of the light emitting package 1. Accordingly, the circuit pattern 115 may be formed of a conductive material such as metal.

The circuit pattern 115 may include an upper pattern 111 formed over the support member 119, a lower pattern 112 formed under the support member 119, and a via 113 formed inside the support member 119.

The upper pattern 111 is electrically connected to the internal components of the light emitting package 1.

The lower pattern 112 is disposed under the support member 119 and is exposed to the outside of the light emitting package 1. Accordingly, the lower pattern 112 may be electrically connected to the external components of the light emitting package 1.

The via 113 is formed to pass through the support member 119, and thus, one end is connected to the upper pattern 111 and another end is connected to the lower pattern 112. Accordingly, the via 113 electrically connects the upper pattern 111 and the lower pattern 112.

As shown in FIG. 3, the upper pattern 111, the lower pattern 112, and the via 113 may be formed in plural.

Referring to FIGs. 3 to 5, the heat dissipation pad 117 may be disposed under the support member 119, and may be disposed between the lower patterns 112. Accordingly, the heat dissipation pad 117 is disposed under a pair of connection pads 128 and the upper patterns 111 of the first optic portion 120. In addition, the heat dissipation pad 117 may be formed to cover a region between the support member 119 and the upper patterns 111.

Since the heat dissipation pad 117 is disposed under a region where the pair of connection pads 128 of the first optic portion 120 are formed, heat generated in the first optic portion 120 may pass through the connection pads 128, the upper patterns 111, and the support member 119 and be transmitted over a shortest distance to the heat dissipation pad 117.

In addition, the heat dissipation pad 117 is spaced apart from the lower patterns 112, but is formed to cover an entire region between the lower patterns 112. The heat dissipation pad 117 formed in this way has a large contact area with the air and may quickly release the heat transferred to the heat dissipation pad 117 into the air.

In this embodiment, the heat dissipation pad 117 is formed wide under a region where the connection pads 128 of the first optic portion 120 and the upper pattern 111 of the substrate 110 are formed, and thus, the heat generated in the first optic portion 120 may be quickly dissipated into the air, thereby improving a luminous efficiency of the light emitting package 1.

Hereafter, when describing other embodiments of the light emitting package, the description will focus on differences from the light emitting package 1 according to the first embodiment. Accordingly, for detailed descriptions of same components as those of the light emitting package 1 according to the first embodiment, refer to the descriptions of FIGs. 1 to 5.

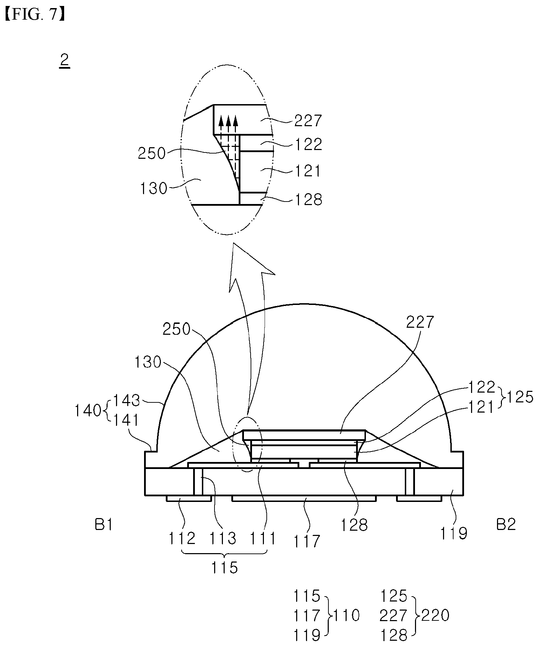

FIG. 6 and FIG. 7 are exemplary diagrams of a light emitting package according to a second embodiment of the present disclosure. FIG. 6 is a plan view of a light emitting package 2 according to the second embodiment of the present disclosure. In addition, FIG. 7 is one cross-sectional view B1-B2 of the light emitting package 2 according to the second embodiment of FIG. 6.

The light emitting package 2 according to the second embodiment may include a substrate 110, a first optic portion 220, a second optic portion 140, a light controller 130, and a separation layer 250.

The first optic portion 220 may include a light generator 125, a connection pad 128, and an optical characteristic converter 227. The light generator 125 may include a first light generation region 121 and a second light generation region 122.

In this embodiment, the optical characteristic converter 227 is formed to cover upper regions of the light generator 125 and the separation layer 250, as shown in FIGs. 6 and 7. That is, the optical characteristic converter 227 is formed to have a larger cross-sectional area than that of the light generator 125.

The separation layer 250 may cover a region of a side surface of the first optic portion 220 and allow light to be emitted from the side surface of the first optic portion 220.

The separation layer 250 is formed under the optical characteristic converter 227 to cover a side surface of the light generator 125. Accordingly, the separation layer 250 is disposed between the light generator 125 and the light controller 130.

Referring to FIG. 7, the separation layer 250 is formed to cover entire side surfaces of the light generator 125. That is, the separation layer 250 may be formed to cover side surfaces of the first light generation region 121 and the second light generation region 122. However, the separation layer 250 may be formed to cover not only the light generator 125 but also a side surface of the connection pad 128.

In addition, the separation layer 250 may be formed of a material that transmits light. For example, the separation layer 250 may be formed of transparent silicone resin.

The light controller 130 is formed to cover the side surface of the first optic portion 220 and an outer surface of the separation layer 250.

The side surface of the light generator 125 and the light controller 130 are spaced apart from each other by the separation layer 250. Accordingly, first light emitted from the side surface of the light generator 125 is directed toward the light controller 130 through the separation layer 250.

First light that reaches the light controller 130 may be reflected from an inner surface of the light controller 130. Herein, the inner surface of the light controller 130 is a surface that faces the light generator 125 and is in contact with the separation layer 250.

In this case, the light controller 130 may have a structure that allows light reaching the inner surface to be reflected toward the optical characteristic converter 227. That is, the inner surface of the light controller 130 may be formed to have a flat or curved surface with an inclination.

In FIG. 7, the inner surface of the light controller 130 is a curved surface that has a tangent slope thereof changes depending on a height thereof. In addition, the inner surface of the light controller 130 has a structure in which a distance from the side surface of the light generator 125 increases from a lower region to an upper region thereof. That is, the separation layer 250 may have a structure in which a thickness of the separation layer 250 on the side surface of the light generator 125 increases from the lower region to the upper region.

However, the structures of the light controller 130 and the separation layer 250 are not limited to the structures shown in FIG. 7. The inner surface of the light controller 130 may be a surface with a constant slope regardless of height.

Light reflected from the inner surface of the light controller 130 may pass through the separation layer 250 again and be directed toward the optical characteristic converter 227 disposed over the separation layer 250. A portion of first light incident into the optical characteristic converter 227 may be converted into second light while passing through the optical characteristic converter 227.

In the light emitting package 2 of this embodiment, after the separation layer 250 is formed to cover the side surfaces of the light generator 125, the light controller 130 may be formed to cover a side surface of the optical characteristic conversion part 227 and the separation layer 250. Accordingly, a structure of the inner surface of the light controller 130, where light is reflected, may be determined depending on a structure of the outer surface of the separation layer 250.

The separation layer 250 may be formed of a silicone resin that has slight spreadability due to low hardness so as to be formed in a structure with the outer surface having an inclination.

In addition, the silicone resins applied to the separation layer 250 and the light controller 130 may have different hardnesses from each other. Furthermore, the silicone resin of the separation layer 250 may have lower hardness than that of the light controller 130.

In addition, the separation layer 250 may include a structure in which a region of the outer surface is flat. In this case, the flat surface may have a different inclination angle from other parts of the outer surface of the separation layer 250. For example, the outer surface of the separation layer 250 may be formed to include a multi-stage structure or a stepped structure. The inner surface of the light controller 130 may also have, depending on such structure of the separation layer 250, a structure in which a region thereof has a different inclination angle from those of other portions, the multi-stage structure, or the stepped structure.

As such, the separation layer 250 provides a space where light emitted from the side surface of the light generator 125 can be reflected from the light controller 130 and incident into the optical characteristic converter 227.

When the light controller 130 is in close contact with the side surface of the light generator 125, once light emitted from the side surface of the light generator 125 is reflected from the light controller 130, light may be re-incident into the inside of the light generator 125.

In addition, even when the separation layer 250 is formed between the light controller 130 and the light generator 125, even in a case that the inner surface of the light controller 130 has a structure parallel to the side surface of the light generator 125, light emitted from the side surface of the light generator 125 may be reflected from the light controller 130 and re-incident into the inside of the light generator 125.

As such, while light emitted from the side surface of the light generator 125 is re-incident to the light generator 125, light loss may occur.

In the light emitting package 2 according to the present embodiment, light emitted from the side surface of the light generator 125 may be reflected by the light controller 130 due to the structures of the separation layer 250 and the light controller 130 and be set to be directed right to the optical characteristic converter 227.

Accordingly, the light emitting package 2 of this embodiment may extract light from the side surface of the light generator 125 as well. In addition, the light emitting package 2 according to this embodiment may reduce light loss that occurs when light emitted from the light generator 125 is re-incident into the light generator 125.

As such, the light emitting package 2 according to this embodiment may extract light from the side surface of the light generator 125 through the separation layer 250, and reduce light loss, thereby increasing an amount of light.

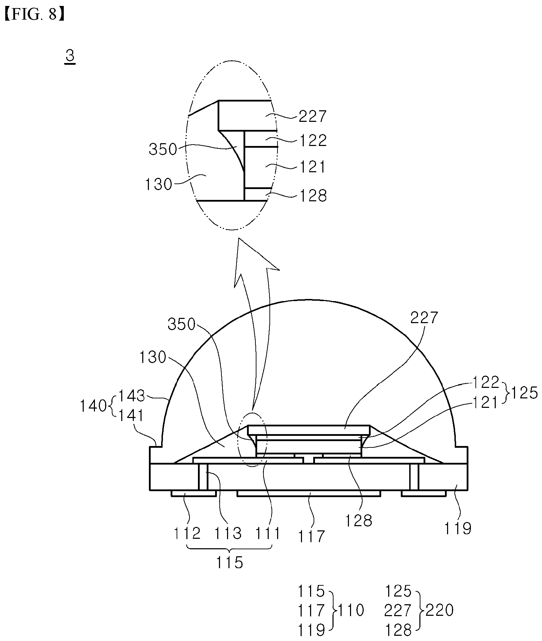

FIG. 8 is an exemplary diagram of a light emitting package according to a third embodiment of the present disclosure.

Referring to FIG. 8, a light emitting package 3 according to the third embodiment may include a substrate 110, a first optic portion 220, a second optic portion 140, a light controller 330, and a separation layer 350.

In this embodiment, the separation layer 350 is formed to cover a region of side surfaces of a light generator 125. For example, the separation layer 350 may be formed to cover more than half of the side surfaces of the light generator 125. Accordingly, as shown in FIG. 8, a bottom of the separation layer 350 may be disposed at a midpoint between a top and a bottom of the light generator 125 or under the midpoint.

However, characteristics of the separation layer 350 are not limited thereto. The separation layer 350 may be formed larger or smaller than the separation layer 350 shown in FIG. 8 as long as a sufficient amount of light can be extracted from the side surfaces of the light generator 125.

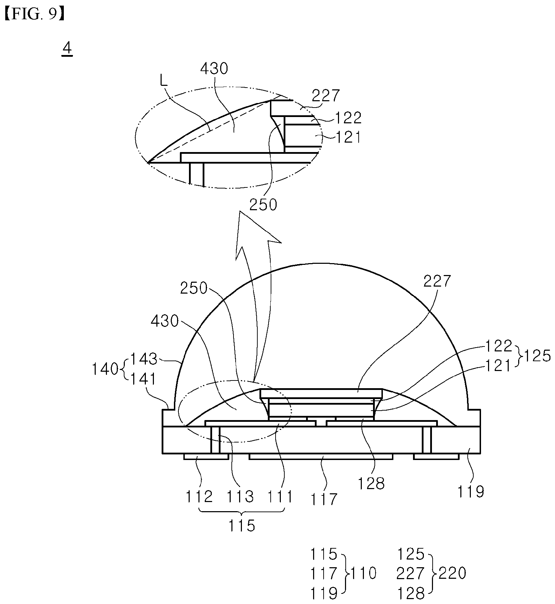

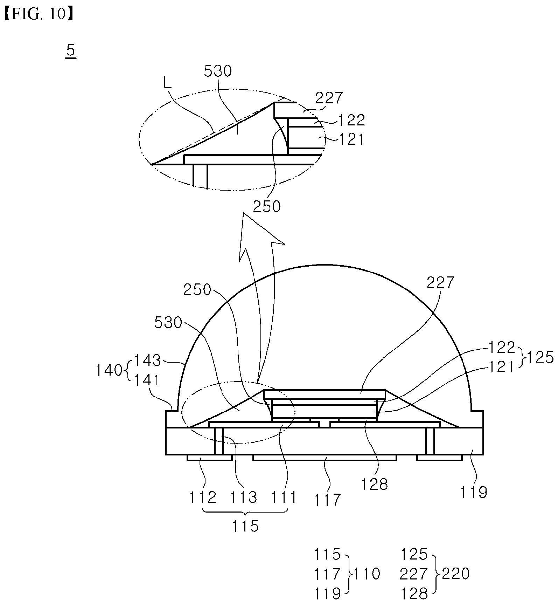

FIG. 9 is an exemplary diagram of a light emitting package according to a fourth embodiment of the present disclosure. In addition, FIG. 10 is an exemplary diagram of a light emitting package according to a fifth embodiment of the present disclosure.

A light emitting package 4 according to the fourth embodiment of FIG. 9 and a light emitting package 5 according to the fifth embodiment of FIG. 10 have different structures of light controllers 430 and 530 from those in the previous embodiment. The light emitting packages 4 and 5 according to the fourth and fifth embodiments may have structures in which outer surfaces of the light controllers 430 and 530 include curved surfaces.

In the light emitting package 4 according to the fourth embodiment, the light controller 430 is formed in a convex structure. In addition, in the light emitting package 5 according to the fifth embodiment, the light controller 430 is formed in a concave structure.

In more detail, referring to FIG. 9, the outer surface of the light controller 430 of the light emitting package 4 according to the fourth embodiment is more convex in an upward direction than a virtual linear line L connecting a top and a bottom of the light controller 430.

When the outer surface of the light controller 430 is formed convex, a thickness of the light controller 430 increases, and a content of a light reflection material dispersed in the light controller 430 also increases accordingly. Accordingly, the light controller 430 of the light emitting package 4 of the fourth embodiment has an increased content of light reflection material, and thus, light reflection efficiency may be improved.

Referring to FIG. 10, the outer surface of the light controller 530 of the light emitting package 5 according to the fifth embodiment is more concave in a downward direction than a virtual linear line L connecting a top and a bottom of the light controller 530.

A space between a first optic portion 120 and a second optic portion 170 may be filled with a light-transmissive material. In this case, when the outer surface of the light controller 530 is formed concave, the light transmissive material may have a structure in which a lower region and an upper region thereof are convex. When the light-transmissive material has the structure in which the upper region and the lower region are convex, light may spread widely while passing through the light-transmissive material and pass through the second optic portion 170. In this case, a light viewing angle of the light emitting package 5 may be widened.

As such, the light emitting packages 4 and 5 may be formed in various structures in addition to a structure in which the light controllers 430 and 530 have a flat outer surface.

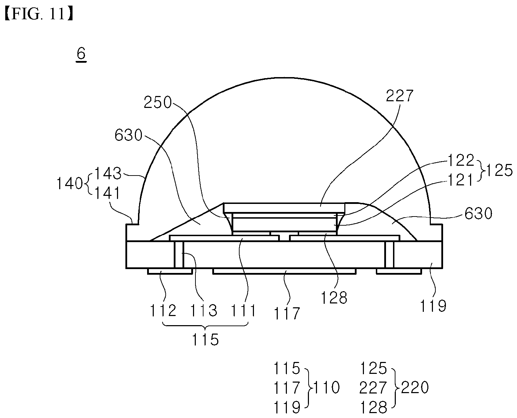

FIG. 11 is an exemplary diagram of a light emitting package according to a sixth embodiment of the present disclosure.

A light emitting package 6 according to the sixth embodiment includes a light controller 630 formed in an asymmetric structure on both side surfaces of a first optic portion 220 with respect to the first optic portion 220. That is, the light controller 630 may have different structures of an outer surface formed on one side of the first optic portion 220 and an outer surface formed on the other side surface thereof.

Referring to FIG. 11, the outer surface of the light controller 630 on one side surface of the first optic portion 220 has a planar structure, and the outer surface of the light controller 630 on the other side surface of the first optic portion 220 has a convex curved structure.

As such, the light controller 630 may be formed to have the different structures on both sides of the first optic portion 220.

When the light controller 630 has the asymmetric structure with respect to the first optic portion 220, other components may be embedded on a bottom of a region with the convex outer surface. In this case, the convex region of the light controller 630 may have a thickness sufficient enough for light reflection efficiency not to be reduced even when other component portions are embedded. Herein, the other component portions embedded in the light controller 630 may be component portions that interrupt a proceeding of light, such as a Zener diode, when exposed to light.

Accordingly, the light emitting package 6 of this embodiment may prevent the light reflection efficiency from being reduced even when the other component portions are embedded in the light controller 630, and since light proceeding to a second optic portion 140 may not interrupted by the other components, the light extraction efficiency may be improved.

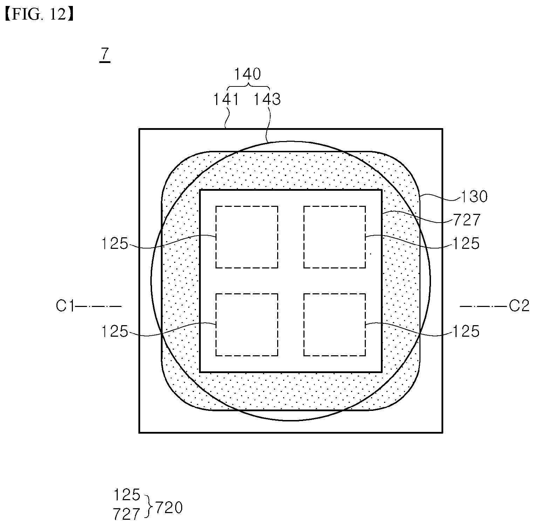

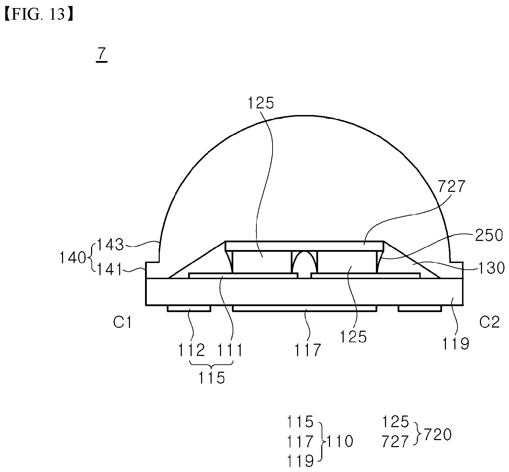

FIG. 12 and FIG. 13 are exemplary diagrams of a light emitting package according to a seventh embodiment of the present disclosure. FIG. 12 is a plan view of a light emitting package 7 according to the seventh embodiment of the present disclosure. In addition, FIG. 13 is one cross-sectional view C1- C2 of the light emitting package 7 according to the seventh embodiment of FIG. 12.

The light emitting package 7 according to the seventh embodiment may include a first optic portion 720 including a plurality of light generators 125.

In FIG. 13, an internal structure of the first optic portion 720 is not shown in detail. However, as described in the previous embodiment, the first optic portion 720 includes all of the first light generation region (121 in FIG. 3), the second light generation region (122 in FIG. 3), and the connection pad (128 in FIG. 3). Hereinafter, the first optic portion 720 is also briefly shown in drawings related to other embodiments. In addition, although not shown in the drawings, a substrate 110 may include a via connecting an upper pattern 111 and a lower pattern 112.

Referring to FIGs. 12 and 13, an optical characteristic converter 727 may be formed to simultaneously cover upper surfaces of the plurality of light generators 125. That is, the plurality of light generators 125 is disposed under a single optical characteristic converter 727.

As shown in FIG. 13, a separation layer 250 may be formed to cover each of side surfaces of the plurality of light generators 125. In this case, the separation layers 250 formed between adjacent light generators 125 may be connected to each other. However, depending on a distance between the adjacent light generators 125 and an amount of material used to form the separation layers 250, the separation layers 250 formed between the light generators 125 may also be spaced apart from each other.

A light controller 130 is formed along an edge of the first optic portion 720 to cover the side surfaces of the plurality of light generators 125 and the separation layer 250. In addition, the light controller 130 may be formed to fill a space formed between the adjacent light generators 125. Accordingly, a structure in which the separation layer 250 covers the light controller 130 may be formed between the adjacent light generators 125.

In this embodiment, the light emitting package 7 includes four first optic portions 720 arranged in a 2X2 matrix. However, the number of first optic portions 720 included in the light emitting package 7 may be changed, and an arrangement structure thereof may also be changed.

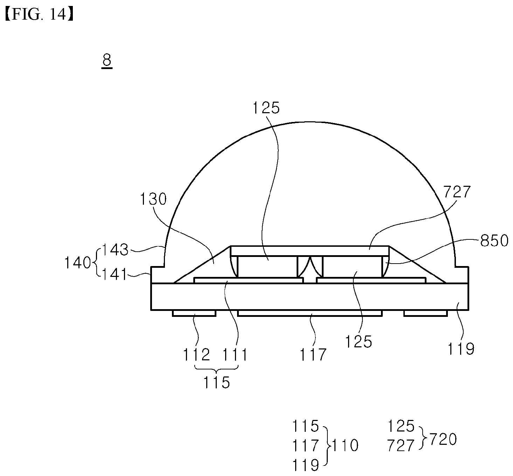

FIG. 14 is a cross-sectional view of a light emitting package according to an eighth embodiment of the present disclosure.

A light emitting package 8 of the eighth embodiment is different from the light emitting package of the seventh embodiment (7 in FIGS. 12 and 13) in a structure of a separation layer 850.

Referring to FIG. 14, the separation layer 850 of this embodiment has a structure in which a thickness on a side surface of a light generator 125 decreases from an upper region to a lower region of the light generator 125. In this case, the separation layer 850 may be formed to have an outer surface that is an outwardly convex curved surface.

A light controller 130 covering the separation layer 850 may have a structure that has a thickness thereof increases from an upper surface of the optical characteristic converter 727 to the lower region of the light generator 125. In this case, since the separation layer 850 has the structure of the convex outer surface, an inner surface of the optical characteristic converter 727 may have a concave curved structure.

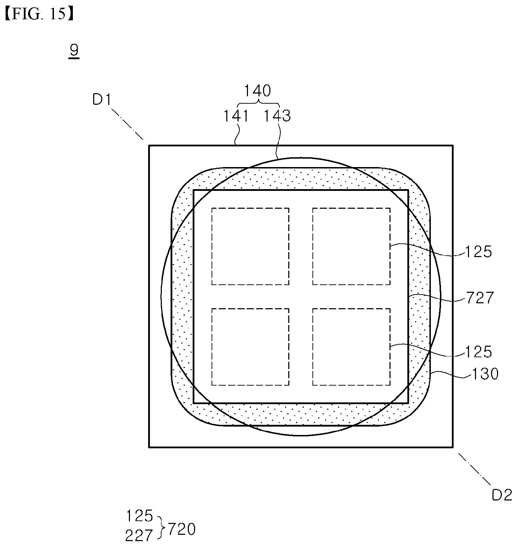

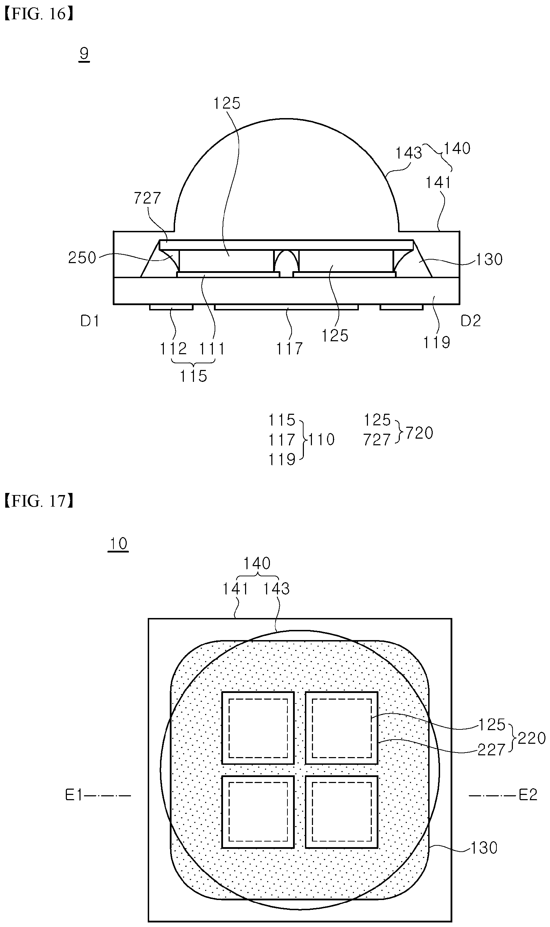

FIG. 15 and FIG. 16 are exemplary diagrams of a light emitting package according to a ninth embodiment of the present disclosure. FIG. 15 is a plan view of a light emitting package 9 according to the ninth embodiment of the present disclosure. In addition, FIG. 16 is one cross-sectional view D1- D2 of the light emitting package 9 according to the ninth embodiment of FIG. 15.

The light emitting package 9 according to the ninth embodiment may include a first optic portion 720 including a plurality of light generators 125. An optical characteristic converter 727 may be formed to simultaneously cover upper surfaces of the plurality of light generators 125. That is, the plurality of light generators 125 is disposed under a single optical characteristic converter 727.

Since the light emitting package 9 of this embodiment includes the plurality of light generators 125, and the optical characteristic converter 727 covers the plurality of light generators 125, an area of the optical characteristic converter 727 increases. That is, an area of a light exiting surface of the first optic portion 720 may increase.

Accordingly, as shown in FIGs. 15 and 16, at least a region of an edge of the first optic portion 720 may be disposed in an outer below of a light emitting region 143 of a second optic portion 140.

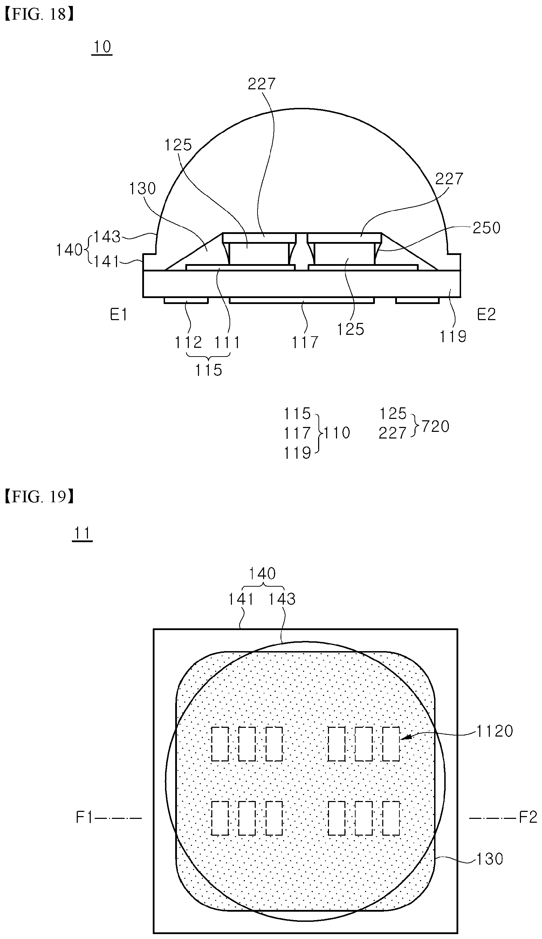

FIG. 17 and FIG. 18 are exemplary diagrams of a light emitting package according to a tenth embodiment of the present disclosure. FIG. 17 is a plan view of a light emitting package 10 according to the tenth embodiment of the present disclosure. In addition, FIG. 18 is one cross-sectional view E1- E2 of the light emitting package 10 according to the tenth embodiment of FIG. 17.

The light emitting package 10 according to the tenth embodiment of the present disclosure includes a plurality of first optic portions 220. Each of the first optic portions 220 includes a light generator 125, an optical characteristic converter 227, and a connection pad (not shown in the drawings).

As shown in FIG. 17, the plurality of first optic portions 220 is arranged to be spaced apart from one another.

In addition, a separation layer 250 is formed to cover side surfaces of the light generator 125 of each of the plurality of first optic portions 220. In this case, the separation layers 250 formed in the first optic portions 220 arranged adjacent to each other may also be spaced apart from each other.

A light controller 130 is formed to cover side surfaces of the plurality of first optic portions 220 and the separation layer 250. Accordingly, the light controller 130 may be also formed in a space between the first optic portions 220 and the separation layers 250 arranged adjacent to each other to cover the first optic portion 220 and the separation layer 250.

According to this embodiment, at least an optical characteristic converter of the plurality of optical characteristic converters 227 may include a different type of optical characteristic conversion material from that of the other optical characteristic converters 227. When the plurality of optical characteristic converters 227 including different optical characteristic conversion materials is included, it is possible to implement improved CIE and CRI in the light emitting package.

In the seventh to tenth embodiments, each light generator in the light emitting package may be a chip-shaped light emitting diode that emits light of a single color.

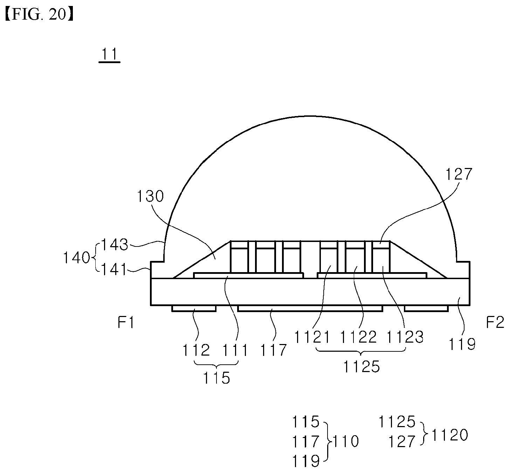

FIG. 19 and FIG. 20 are exemplary diagrams of a light emitting package according to a 11th embodiment of the present disclosure. FIG. 19 is a plan view of a light emitting package 11 according to the 11th embodiment of the present disclosure. In addition, FIG. 20 is one cross-sectional view E1- E2 of the light emitting package 11 according to the 11th embodiment of FIG. 19.

The light emitting package 11 according to the 11th embodiment includes a plurality of first optic portions 1120 and a light controller 130 surrounding side surfaces of the first optic portion 1120. Each of the first optic portions 1120 may include a light generator 1125, an optical characteristic converter 127, and a connection pad (not shown in the drawings).

In the light emitting diode package 11 according to the 11th embodiment, the light generator 1125 may include a plurality of light emitting diodes.

For example, the light generator 1125 may include a first light generation region 1121, a second light generation region 1122, and a third light generator 1123. That is, each of the first through third light generators 1121, 1122, and 1123 is formed of the light emitting diode.

In addition, the optical characteristic converter 127 may be formed over each of the first through third light generators 1121, 1122, and 1123. Alternatively, the optical characteristic converter 127 may be formed over portions of the plurality of light emitting diodes forming the light generator 1125.

The first through third light generators 1121, 1122, and 1123 may emit light of a same color or light of different colors.

For example, the first light generation region 1121 may emit red light, the second light generation region 1122 may emit green light, and the third light generator 1123 may emit blue light. In this way, each of the light generators 1125 that simultaneously emits different lights may become a pixel.

In this embodiment, the light generator 1125 includes the first through third light generators 1121, 1122, and 1123, but the inventive concepts are not limited thereto. A type and a number of light emitting diodes forming the light generator 1125 may be changed in various ways.

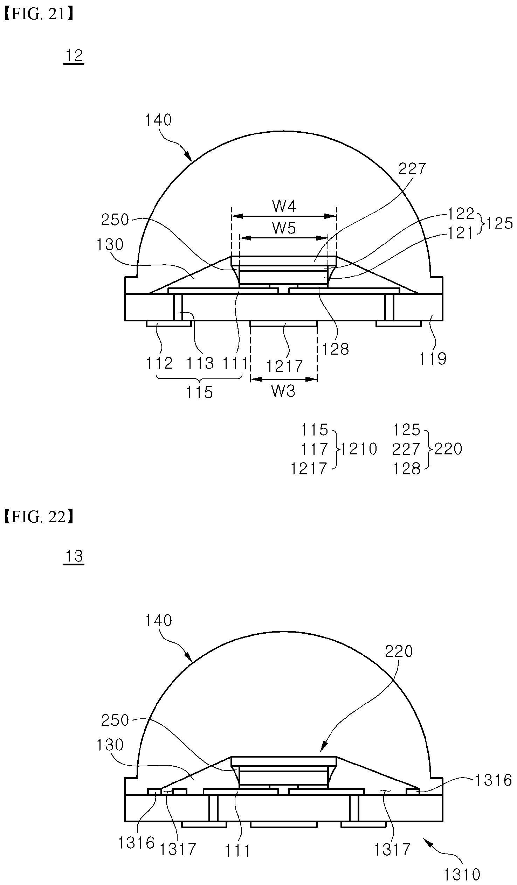

FIG. 21 is an exemplary diagram of a light emitting package according to a 12th embodiment of the present disclosure.

Referring to FIG. 21, a substrate 1210 may include a support member 119, a circuit pattern 115, and a heat dissipation pad 1217.

In this embodiment, the heat dissipation pad 1217 may be formed to have a smaller width than that of a first optic portion 220. (W3<W4) Furthermore, the heat dissipation pad 1217 may be formed to have a narrower width than that of a light generator 125. (W3< W5)

In a light emitting package 12 of this embodiment, a connection pad 128, an upper pattern 111, and the heat dissipation pad 1217, which are formed under the light generator 125, are arranged to be staggered with one another. Referring to FIG. 21, both ends of the connection pad 128, both ends of the upper pattern 111, and both ends of the heat dissipation pad 1217 are not disposed on a same perpendicular line, but are staggered one another. Accordingly, a region where the connection pad 128, the upper pattern 111, and the heat dissipation pad 1217 overlap with one another in a vertical direction may be minimized. Therefore, the light emitting package 12 of this embodiment may minimize a region to be formed in the substrate 1210 where materials having stress and thermal expansion coefficients different from those of the support member 119 are concentrated.

In addition, both ends of the upper pattern 111 and both ends of the lower pattern 112 may also be arranged to be staggered each other in the vertical direction.

Accordingly, the light emitting package 12 of this embodiment may prevent a deformation and a damage of the substrate 1210 by forming the substrate 1210 in a structure that may disperse stress and minimize the region where stress is concentrated.

FIG. 22 is an exemplary diagram of a light emitting package according to a 13th embodiment of the present disclosure.

A substrate 1310 of a light emitting package 13 of this embodiment may further include a dummy pattern 1316 formed on a support member 119.

A plurality of dummy patterns 1316 is formed on an upper surface of the support member 119. In addition, the dummy pattern 1316 may be arranged to be spaced apart from an upper pattern 111.

Referring to FIG. 22, the dummy patterns 1316 may be arranged on both sides of a first optic portion 220, respectively. Two dummy patterns 1316 may be arranged side by side on one side of the first optic portion 220, and one dummy pattern 1316 may be arranged on the other side of the first optic portion 220.

A concave space 1317 is formed between the dummy pattern 1316 and the upper pattern 111 with respect to upper surfaces of the dummy pattern 1316 and the upper pattern 111. That is, the concave space 1317 is a space in which the dummy pattern 1316 and the upper pattern 111 are not formed and the upper surface of the support member 119 is exposed to.

In addition, the dummy patterns 1316 arranged side by side may also be spaced apart from each other, and thus, the concave space 1317 may be formed therebetween

When a material for forming a light controller 130 is applied on the substrate 1310, the dummy pattern 1316 may function as a dam.

For example, the material for forming the light controller 130 may be silicone resin.

To form the light controller 130, a predetermined amount of silicone resin may be applied to the substrate 1310.

In this case, an amount of silicone resin applied to the substrate 1310 may increase due to tolerance, or the silicone resin may be widely applied to the substrate 1310 due to a flowability of the silicone resin.

In this case, even when a larger amount of silicone resin is applied than an amount thereof that has been designed, a portion of the silicone resin may fill the concave space 1317, thereby preventing the silicone resin from being applied outside a predetermined region. That is, the concave space 1317 may be a space to be filled with silicone resin that is more applied than designed.

In addition, the dummy pattern 1316 in this embodiment may limit a region where the light controller 130 is formed. The dummy pattern 1316 may block the flow of the silicone resin applied to the substrate 1310 and prevent the silicone resin from flowing to the outside of the dummy pattern 1316.

Referring to FIG. 22, the dummy pattern 1316 such as the dummy pattern formed on one side of the first optic portion 220 may play a role to prevent the flow of silicone resin forming the light controller 130. In addition, the dummy pattern 1316 such as the dummy pattern formed on the other side of the first optic portion 220 may play a role to form a space that fills a portion of the silicone resin overapplied due to the tolerance.

As such, the dummy pattern 1316 may allow the light controller 130 formed within an arbitrary pre-designed region.

The dummy pattern 1316 of this embodiment may also be applied to a light emitting package in which the previously described first optic portion 220 is provided singly or in plurality.

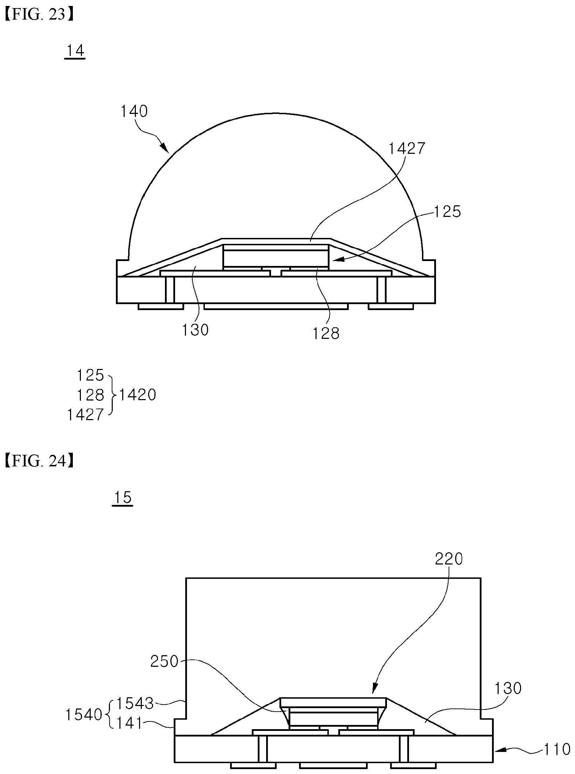

FIG. 23 is an exemplary diagram of a light emitting package according to a 14th embodiment of the present disclosure.

A light emitting package 14 according to the 14th embodiment may include a substrate 110, a first optic portion 1420, a second optic portion 140, and a light controller 130.

The first optic portion 1420 may include a light generator 125, a connection pad 128, and an optical characteristic converter 1427.

Referring to FIG. 23, the optical characteristic converter 1427 of this embodiment may be formed to cover both the light generator 125 and the light controller 130.

The light controller 130 includes a reflective material, and reflects light emitted from a side surface of the light generator 125. However, most of light emitted through the side surface of the light generator 125 is reflected by the light controller 130, but some of it may pass through the light controller 130.

The optical characteristic converter 1427 of this embodiment is formed to cover the light controller 130, and may change characteristics of light passing through the light controller 130.

Accordingly, the light emitting package 14 of this embodiment may allow not only light emitted through an upper surface of the light generator 125 but also light passing through the light controller 130 incident into the optical characteristic converter 1427.

Accordingly, the light emitting package 14 of this embodiment may allow light of a uniform color to emit throughout the first optic portion 1420.

A structure of the optical characteristic converter 1427 of the light emitting package 14 of this embodiment may be applied to the light emitting package of various embodiments described previously.

FIG. 24 is an exemplary diagram of a light emitting package according to a 15th embodiment of the present disclosure.

A light emitting package 15 according to the 15th embodiment may include a substrate 110, a first optic portion 220, a second optic portion 1540, and a light controller 130.

The second optic portion 1540 may include a securing region 141 and a light emitting region 1543.

Referring to FIG. 24, the light emitting region 1543 of this embodiment may be formed of flat surfaces.

In addition, the second optic portion 1540 of this embodiment is formed under the light emitting region 1543, and includes the securing region 141 having a width larger than that of the light emitting region 1543. However, a structure of the second optic portion 1540 of this embodiment is not limited thereto. In the second optic portion 1540 of this embodiment, the securing region 141 may be omitted, and the light emitting region 1543 may be attached to the substrate 110 so as to cover an entire upper surface of the substrate 110. Alternatively, the second optic portion 1540 of this embodiment may be formed such that the light emitting region 1543 disposed on the securing region 141 has a same width as that of the securing region 141.

In addition, the light emitting package 15 of this embodiment includes one first optic portion 220, but the inventive concepts are not limited thereto. The second optic portion 1540 of the light emitting package 15 of this embodiment may be applied to the light emitting package of various embodiments described previously.

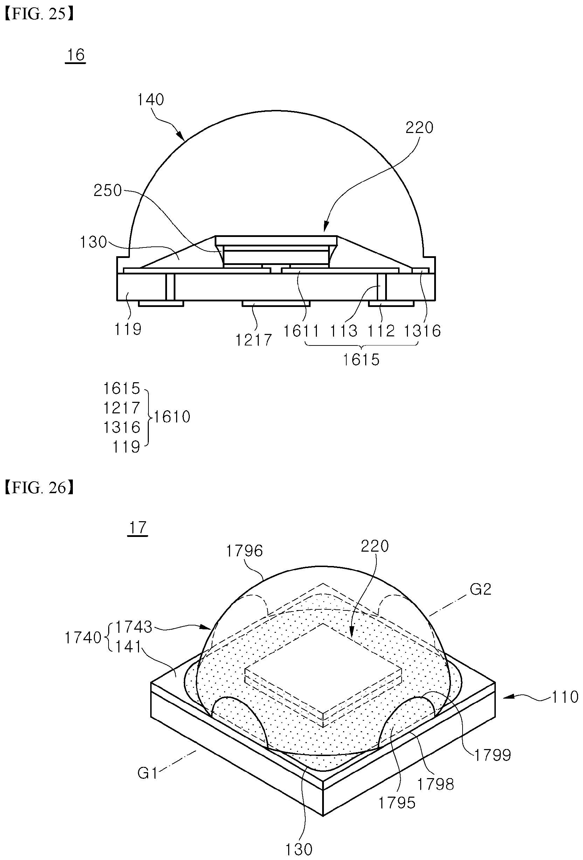

FIG. 25 is an exemplary diagram of a light emitting package according to a 16th embodiment of the present disclosure.

A light emitting package 16 according to the 16th embodiment may include a substrate 1610, a first optic portion 220, a second optic portion 140, a separation layer 250, and a light controller 130.

Referring to FIG. 25, the light emitting package 16 of this embodiment may have a structure in which a region of an upper pattern 1611 is exposed from the light controller 130. That is, the upper pattern 1611 may be formed to have a larger cross-sectional area than that of a lower cross-sectional area of the light controller 130. Alternatively, the light controller 130 may be formed such that a region of the upper pattern 1611 is exposed.

Accordingly, the upper pattern 1611 formed of a conductive material such as metal may be exposed to an internal space of the second optic portion 140. Therefore, heat generated in the first optic portion 220 may be emitted to the outside through the upper pattern 1611. In this case, in a region of the upper pattern 1611 covered with the light controller 130, heat conducted to the upper pattern 1611 may be released to the outside of the light emitting package 16 through the light controller 130 and the second optic portion 140. However, in a region of the upper pattern 1611 that is not covered with the light controller 130, heat conducted to the upper pattern 1611 may be released to the outside of the light emitting package 16 through only the second optic portion 140.

As such, the light emitting package 16 according to this embodiment may efficiently release heat to the outside of the light emitting package 16 through the exposed region of the upper pattern 1611, and thus, heat dissipation effect may be improved.

FIG. 26 through FIG. 28 are exemplary diagrams of a light emitting package according to a 17th embodiment of the present disclosure.

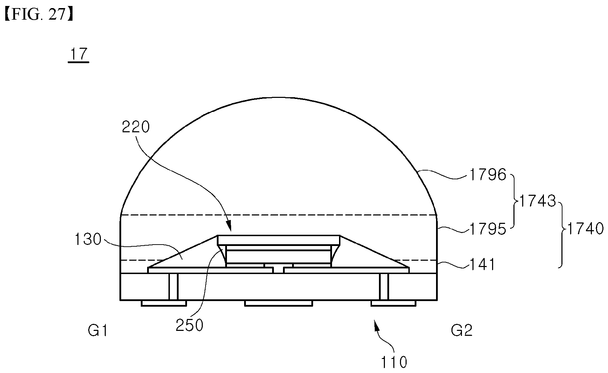

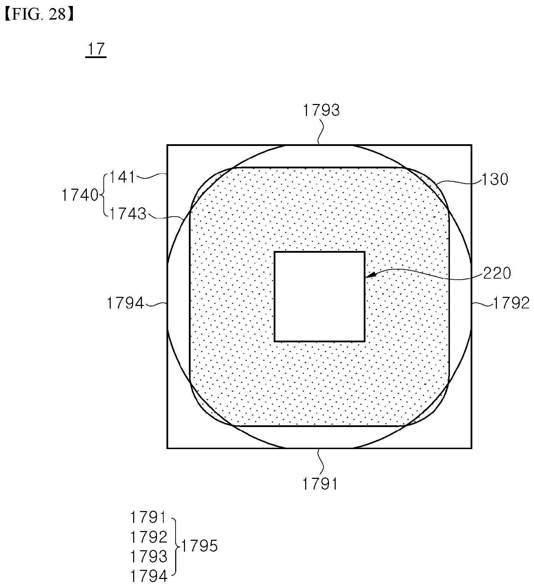

FIG. 26 is a perspective view of the light emitting package according to the 17th embodiment of the present disclosure. FIG. 27 is a cross-sectional view (G1-G2) of the light emitting package according to the 17th embodiment of the present disclosure. In addition, FIG. 28 is a plan view of the light emitting package according to the 17th embodiment of the present disclosure.

A light emitting package 17 according to the 17th embodiment may include a substrate 110, a first optic portion 220, a second optic portion 1740, a separation layer 250, and a light controller 130.

The second optic portion 1740 may include a securing region 141 and a light emitting region 1743.

Referring to FIG. 26 through FIG. 28, the light emitting region 1473 may be formed in a structure including a curved surface 1796 that is convex upward and a flat surface 1795. The flat surface 1795 may be formed to be connected to a region of an edge of the light emitting region 1473. In addition, the flat surface 1795 may be formed perpendicular on a bottom edge of the light emitting region 1473. In addition, as shown in FIG. 27, the flat surface 1795 is disposed over the securing region 141, and is disposed on a same perpendicular line as the securing region 141. As such, the flat surface 1795 may be disposed at a point where an edge of the securing region 141 and the edge of the light emitting region 1473 meet.

In addition, referring to FIG. 26, an edge of the flat surface 1795 may be formed of a linear line and a curve. That is, a lower edge 1798 of the flat surface 1795 may be formed as a linear line, and an upper edge 1799 connected to both ends of the lower edge 1798 may be formed as a curve. In this case, the upper edge 1799 of the flat surface 1795 may have a same curvature as that of the curved surface 1796 of the light emitting region 1473. That is, a shortest distance between the upper edge 1799 and the curved surface 1796 of the light emitting region 1473 may be same at any points.

Referring to FIG. 28, the flat surface 1795 may include a first flat surface 1791, a second flat surface 1792, a third flat surface 1793, and a fourth flat surface 1794. The first flat surface 1791 and the third flat surface 1793 may be disposed to face each other, and the second flat surface 1792 and the fourth flat surface 1794 may also be disposed to face each other.

In addition, the first through fourth flat surfaces 1791, 1792, 1793, and 1794 may be formed parallel to side surfaces of the first optic portion 220 or side surfaces of the substrate 110, respectively. In addition, the first through fourth flat surfaces 1791, 1792, 1793, and 1794 may be formed to have a narrower width than that of the side surface of the substrate 110 facing them, respectively.

Some of light emitted from the first optic portion 220 may be directed toward the first surface 1791. In addition, some of light reflected from the first surface 1791 may be directed toward the third surface 1793 facing the first surface 1791. In addition, some of light reflected from the third surface 1793 may be directed toward the first surface 1791 facing the third surface 1793. For example, some light may be reflected from the first surface 1791 to be directed toward the third surface 1793, and reflected again from the third surface 1793 to be directed toward the first surface 1791 to repeat this operation.

That is, some light may be repeatedly reflected from the first surface 1791 and the third surface 1793 that face each other. In addition, some light may be repeatedly reflected in the second surface 1792 and the fourth surface 1794 that face each other.

As such, some of light may be repeatedly reflected by the flat surfaces 1795 facing each other disposed on both ends of the light emitting region 1473 and then be directed upward.

Accordingly, the light emitting package 17 of this embodiment may reduce a light viewing angle by forming the flat surfaces 1795 that face each other in the second optic portion 1740. For example, in the light emitting package 17 of this embodiment, the light viewing angle may be set to be 120 degrees or less through the second optic portion 1740 in which the flat surfaces 1795 facing each other are formed.

The second optic portion 1740 of the light emitting package 17 of this embodiment may be applied to the light emitting package of various embodiments described previously.

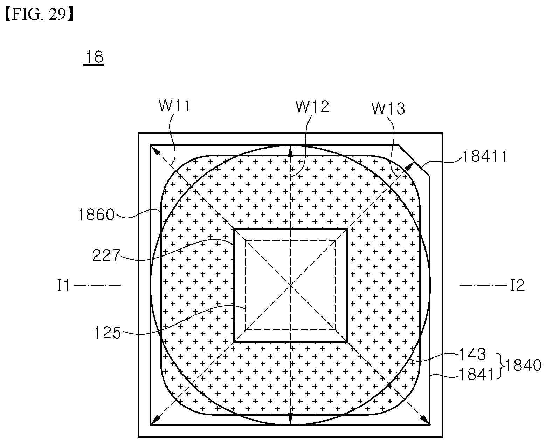

FIG. 29 through FIG. 31 are exemplary diagrams of a light emitting package according to a 18th embodiment of the present disclosure.

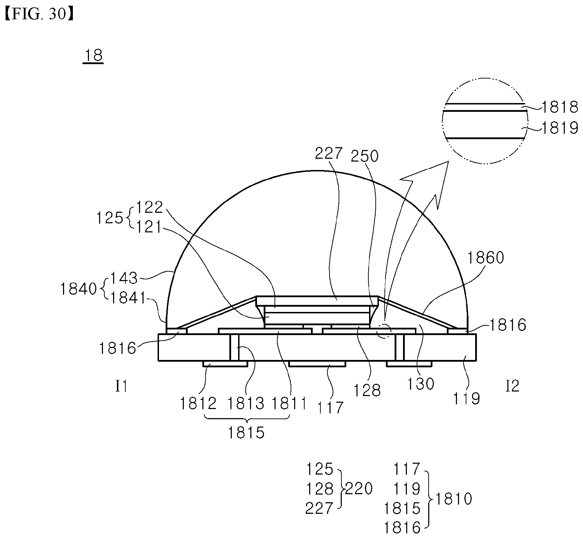

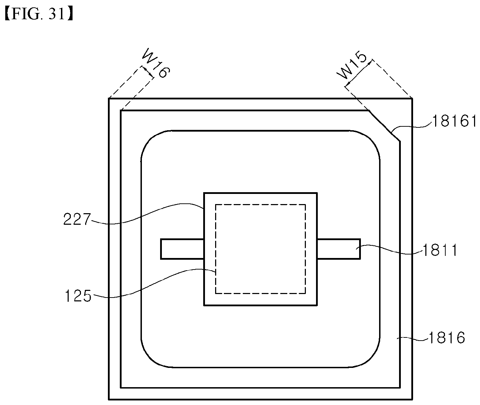

FIG. 29 is a plan view of a light emitting package 18 according to the 18th embodiment of the present disclosure. FIG. 30 is a cross-sectional view I1- I2 of the light emitting package 18 according to the 18th embodiment of the present disclosure. In addition, FIG. 31 is a plan view illustrating a dummy pattern 1816 of the light emitting package 18 according to the 18th embodiment of the present disclosure.

The light emitting package 18 according to the 18th embodiment may include a substrate 1810, a first optic portion 220, a second optic portion 1840, a light controller 130, a buffer layer 1860, and a separation layer 250.

The substrate 1810 of the light emitting package 18 of this embodiment may include a support member 119, an upper pattern 1811, and a dummy pattern 1816.

According to this embodiment, a circuit pattern 1815 may include the upper pattern 1811, a lower pattern 1812, a via 1813, the dummy pattern 1816, and a heat dissipation pattern 117.

Referring to FIG. 30, the upper pattern 1811 may include a first pattern layer 1818 and a second pattern layer 1819 formed over the first pattern layer 1818.

The first pattern layer 1818 and the second pattern layer 1819 may be formed of different conductive materials from each other. In addition, the first pattern layer 1818 and the second pattern layer 1819 may have a same thickness or may have different thicknesses from each other. For example, among the first pattern layer 1818 and the second pattern layer 1819, the first pattern layer 1818 which is disposed relatively closer to the support member 119 may be formed to have a thickness thicker than that of the second pattern layer 1819. Furthermore, the thickness of the second pattern layer 1819 may be about 5% to 15% of the thickness of the first pattern layer 1818.

In addition, the first pattern layer 1818 may have a higher coefficient of thermal expansion than that of the second pattern layer 1819. When the second pattern layer 1819 which has a smaller thermal expansion coefficient than that of the support substrate 119 is formed on an upper surface of the support member 119, the upper pattern 1811 may be peeled off from the support substrate 119 or cracks may occur due to a difference in thermal expansion coefficient. Therefore, by forming the first pattern layer 1818 having the higher thermal expansion coefficient than that of the second pattern layer 1819 between the support member 119 and the second pattern layer 1819, it is possible to prevent the upper pattern 1811 from being peeled off or cracks from occurring in the upper pattern 1811 on an interface between the support member 119 and the upper pattern 1811.

For example, a material forming the first pattern layer 1818 may include copper, and a material forming the second pattern layer 1819 may include nickel. However, the materials forming the first pattern layer 1818 and the second pattern layer 1819 are not limited thereto. The first pattern layer 1818 and the second pattern layer 1819 may be formed of any material that satisfies the above-mentioned conditions.

Other patterns included in the circuit pattern 1815 may also include a plurality of pattern layers like the upper pattern 1811. That is, the lower pattern 1812 may have a structure in which the first pattern layer 1818 and the second pattern layer 1819 are sequentially stacked under the support member 119. In addition, the via 1813 may also have a structure in which the first pattern layer 1818 and the second pattern layer 1819 are sequentially stacked on an inner wall of the support member 119.

In this embodiment, the circuit pattern 1815 includes two pattern layers, but the inventive concepts are not limited thereto, and may include more pattern layers. In addition, depending on a method of forming the circuit pattern 1815, structures and compositions of the pattern layers forming the upper pattern 1811, the lower pattern 1812, and the via 1813 may be different. For example, at least one of the lower pattern 1812 or the via 1813 may be formed as a single layer or may include a plurality of pattern layers different from the upper pattern 1811.

In addition, in this embodiment, the circuit pattern 1815 is formed of the plurality of layers, but the inventive concepts are not limited thereto, and may be formed as a single layer.

The dummy pattern 1816 may be formed of a conductive material. The dummy pattern 1816 may be formed of a material with high electrical conductivity. In addition, the dummy pattern 1816 may be formed of a material with high thermal conductivity. In addition, the dummy pattern 1816 may be formed of a material that has both high electrical conductivity and high thermal conductivity. For example, the dummy pattern 1816 may be formed of a same material as that of the circuit pattern. When the dummy pattern 1816 is formed of the same material as that of the circuit pattern, it may be formed simultaneously through a same process as that of the circuit pattern. The material forming the dummy pattern 1816 is not limited to a conductive material, and the dummy pattern 1816 may be formed of an insulating material.

Referring to FIG. 31, the dummy pattern 1816 may be formed along edges of the support member 119, and have a structure surrounding the first optic portion 220 and the upper pattern 1811. In this case, the dummy pattern 1816 may be spaced apart from the upper pattern 1811 and the first optic portion 220 and insulated from each other.

Outer edges of the dummy pattern 1816 may be formed in a polygonal shape. More specifically, the outer edges of the dummy pattern 1816 may be formed along the edges of the support member 119, and may be spaced apart from the edges of the support member 119. In this case, the outer edges of the dummy pattern 1816 may have a structure in which at least a region among regions of the outer edges facing corners of the support member 119 has an inclined surface 18161 rather than a corner.

Referring to FIG. 31, the dummy pattern 1816 of this embodiment includes a single inclined surface 18161 on which an outer edge thereof faces the corner of the support member 119. However, the structure of the dummy pattern 1816 is not limited thereto, and the dummy pattern 1816 may have a structure that the outer edges include a plurality of inclined surfaces 18161 facing the corners of the support member 119.

Referring to FIG. 31, W15 may be larger than W16. Herein, the W15 is a distance between the inclined surface 18161 of the dummy pattern 1816 and the corner of the support member 119 adjacent to the inclined surface 18161. In addition, the W16 is a distance between the corner of the outer edge of the dummy pattern 1816 and the corner of an outer edge of the support member 119 adjacent to the corner of the outer edge of the dummy pattern 1816.

In addition, inner edges of the dummy pattern 1816 may be formed along the outer edges thereof, and may have a structure with curved corners.

When the corner of the inner edges of the dummy pattern 1816 is right-angled, a region between inner surfaces of the dummy pattern 1816 forming the corner narrows sharply toward a vertex of the corner. When the region between the inner surfaces of the dummy pattern 1816 becomes too narrow, the region may not be filled with a material forming the light controller 130. That is, the light controller 130 is not in close contact with entire inner surfaces of the dummy pattern 1816, and a region may be formed where the inner surfaces of the dummy pattern 1816 and the light controller 130 are spaced apart. Depending on a viscosity of the material forming the light controller 130, the region where the inner surfaces of the dummy pattern 1816 and the light controller 130 are spaced apart may become wider.

In addition, since the light controller 130 is formed to fill the region between the inner surfaces forming the corner of the inner edges of the dummy pattern 1816, the light controller 130 is also formed to have a structure that a bottom corner thereof corresponds to the inner edge of the dummy pattern 1816. That is, when the corner of the inner edges of the dummy pattern 1816 is right-angled, the corner of a bottom edge of the light controller 130 is also right-angled. When the bottom corner of the light controller 130 has the right-angled structure, a cross-section of the bottom of the light controller 130 significantly changes toward the vertex of the corner. In this case, as the cross-section is greatly reduced at the bottom corner of the light controller 130, stress may be concentrated and cracks may occur.

In addition, when the corner of the inner edges of the dummy pattern 1816 has the right-angled structure, the corner of the inner surfaces of the dummy pattern 1816 and the bottom edge of the light controller 130 may be spaced apart due to a surface tension of the material forming the light controller 130. Accordingly, when the corner of the inner surface of the dummy pattern 1816 is right-angled, adhesion may decrease due to a decrease in a contact area between the light controller 130 and the dummy pattern 1816.

In addition, when the light controller 130 is peeled off from the dummy pattern 1816, light from the first optic portion 220 may be exposed to the outside through a peeled portion. Accordingly, the light controller 130 cannot sufficiently perform a role of guiding light generated in the first optic portion 220 to be emitted in a predetermined direction.

The corner of the dummy pattern 1816 of this embodiment is formed as the curved surface with a curvature rather than the right angle, and thus, the material forming the light controller 130 may fill the region adjacent to the inner surface of the dummy pattern 1816 regardless of viscosity. In addition, a curved structure of the corner of the inner edges of the dummy pattern 1816 may be formed by considering the surface tension of the material forming the light controller 130. That is, the light controller 130 may be formed to be in close contact with the entire inner surfaces of the dummy pattern 1816 without any separation space with the inner surface of the dummy pattern 1816. Accordingly, the decrease in adhesion due to the decrease in the contact area between the dummy pattern 1816 and the light controller 130 may be prevented, and thus, a reliability of the light emitting package 18 may be improved.

In addition, the curved structure of the corner of the inner edges of the dummy pattern 1816 may be formed by considering a gravity center of the material forming the light controller 130. The gravity center of the light controller 130 may be concentrated at the corner of the inner edges of the dummy pattern 1816. Accordingly, the gravity center of the light controller 130 may be dispersed by forming the corner of the inner edges of the dummy pattern 1816 with the curved surface having the curvature rather than the right angle. Accordingly, the light controller 130 may be prevented from overflowing to the outside of the dummy pattern 1816.

In addition, it is possible to prevent light from the first optic portion 220 from leaking into the peeled region where the light controller 130 and the substrate 1810 are peeled off.

In addition, according to this embodiment, the light controller 130 may also be formed to have the curved structure at the bottom corner thereof due to the structure of the inner edge of the dummy pattern 1816. Since the bottom corner of the light controller 130 has the curved structure, a cross-sectional change is reduced compared to when it has the right-angled structure. Accordingly, the light controller 130 may disperse stress relatively better than when the bottom corner is right-angled, and thus, it is possible to prevent cracks from occurring due to stress concentration.

In this embodiment, the dummy pattern 1816 may play a same role as that of the dummy pattern 1316 of the light emitting package (13 in FIG. 22) according to the 13th embodiment. That is, the dummy pattern 1816 of this embodiment may control the region on which the light controller 130 is formed when the light controller 130 is formed on the substrate 1810. The light controller 130 may be formed in an inner region of the outer edge of the dummy pattern 1816. In addition, the bottom edge of the light controller 130 may have a shape corresponding to the inner edge or outer edge of the dummy pattern 1816.

According to this embodiment, the buffer layer 1860 may be formed between the light controller 130 and the second optic portion 1840.

The buffer layer 1860 may prevent the second optic portion 1840 from being separated from the light emitting package 18 due to heat or external impact. The buffer layer 1860 may prevent the second optic portion 1840 from being separated from the light controller 130 due to a difference in thermal expansion coefficient between the light controller 130 and the second optic portion 1840. In addition, by improving the adhesion between the light controller 130 and the second optic portion 1840, the buffer layer 1860 may prevent the second optic portion 1840 from being separated from the light controller 130 due to the external impact.

A material forming the buffer layer 1860 may include at least a materials of the materials forming the light controller 130 or the second optic portion 1840. Alternatively, the buffer layer 1860 may be formed including at least a material of the materials forming the light controller 130 and the second optic portion 1840. Alternatively, the buffer layer 1860, the light controller 130, and the second optic portion 1840 may include at least a same material. For example, the buffer layer 1860, the light controller 130, and the second optic portion 1840 may include silicone.

According to this embodiment, a thickness of the buffer layer 1860 may be about 30 µm or less. Further, the thickness of the buffer layer 1860 may be about 10 µm or less. Furthermore, the thickness of the buffer layer 1860 may be less than twice of a thickness of the first light generation region 121.

The second optic portion 1840 is formed over the substrate 1810, and may be formed to cover the first optic portion 220, the light controller 130, the buffer layer 1860, and the separation layer 250. In this case, a bottom edge of the second optic portion 1840 may be formed along the outer edge of the dummy pattern 1816. Accordingly, on the inclined surface 18161 of the outer edge of the dummy pattern 1816, the second optic portion 1840 may also be formed such that its bottom edge has an inclined surface 18411. That is, when the bottom edge of the second optic portion 1840 of the present embodiment has a polygonal structure, the bottom edge thereof may have a structure having the inclined surface 18411 at a region facing at least a corner of the corners of the support member 119. The second optic portion 1840 may include the light emitting region 143 and a securing region 18411 disposed under the light emitting region 143. The bottom edge of the second optic portion 1840 is an outer edge of a bottom of the securing region 18411.

Referring to FIG. 29, the second optic portion 1840 of the present embodiment has a structure in which a region facing one corner of the support member 119 has the inclined surface 18411. Accordingly, the second optic portion 1840 have different widths between the bottom edges disposed on two diagonals of the support member 119 in plane view. It may be W11> W12. Herein, the W11 is a longest width among the widths between the bottom edges of the second optic portion 1840. That is, the W11 is the width between corners facing each other among the bottom edges of the second optic portion 1840. In addition, the W12 is a distance between a corner disposed on a perpendicular line of the W11 among the bottom edges of the second optic portion 1840 and the inclined surface 18411.

Furthermore, the second optic portion 1840 may have different widths between the bottom edges disopsed on the two diagonals of the support member 119 and between the bottom edges disposed on the central axis of the support member 119 in plan view. Moreover, the width of the bottom edge of the second optic portion 1840 disposed on the central axis of the support member 119 may be smaller than the other two diagonals. That is, it may be W11 > W12 > W13. Herein, the W13 may be a largest width among the widths of the bottom edges disposed on the central axis of the support member 119.

The second optic portion 1840 may be stressed by external heat or heat generated from the first optic portion 220 and the substrate 1810. In this case, thermal stress may spread from a center of the second optic portion 1840 toward the outside. That is, the stress may spread from a center toward the outside along the diagonal or central axis for each diagonal of the bottom edges of the second optic portion 1840. When the diagonals of the bottom edge of the second optic portion 1840 have a same length, centers of the diagonals that receive a greatest stress coincide with a center of the central axis. In this case, the stress is concentrated at the center of the second optic portion 1840, and cracks occur in the second optic portion 1840 in a region where the stress is concentrated, or the second optic portion 1840 may be peeled off from the first optic portion 220.

In this embodiment, since the W11 and the W12 which are lengths of the diagonals of the bottom edge of the second optic portion 1840 are different from each other, the centers where the stress is concentrated for each diagonal do not coincide with each other. Accordingly, in this embodiment, the region where the stress is concentrated in the second optic portion 1840 may be dispersed, thereby preventing the cracks and peeling.

In addition, according to this embodiment, the second optic portion 1840 may be formed of a material that transmits light. Further, the second optic portion 1840 may include a resin through which light transmits and fluorine dispersed in the resin. Fluorine dispersed in the resin may prevent discoloration and deterioration of the second optic portion 1840 by ultraviolet rays when the first optic portion 220 emits the ultraviolet rays, especially when the ultraviolet rays have a peak wavelength of 370 nm or less.

Through the embodiments of the present disclosure, it has been described that the light emitting packages include the light controller 130. However, the light controller 130 is not necessarily included in the light emitting packages.

In addition, when the light emitting packages emit light toward a side direction, the second optic portions 140 and 1840 may be disposed on the side surface of the light generator 125. In this case, the light controller 130 surrounding the side surfaces of the light generator 125 may be omitted.

Alternatively, the light controller 130 may be formed in a downward direction of the light generator 125. That is, the light controller 130 may be formed between the light generator 125 and the substrates 110, 1210, 1310, 1610, and 1810.

Alternatively, the light controller 130 may be formed to fill grooves that are spaces between the upper patterns 111, 1611, and 1811 and the dummy patterns 1316 and 1816 of the substrates 1310, 1610, and 1810. In this case, the light controller 130 may be formed to cover the inner surfaces of the dummy patterns 1316 and 1816, or further to extend to the upper surfaces of the dummy patterns 1316 and 1816 to cover at least a region of the upper surfaces of the dummy patterns 1316 and 1816.

Through FIG. 1 through FIG. 31, the light emitting packages according to various embodiments have been described. However, the structure of the light emitting package of the present disclosure is not limited to the structure shown in the drawings for each embodiment. The features of the lighting light emitting package described in each embodiment may be applied to the light emitting package of other embodiments.

As described above, the detailed description of the present disclosure has been made by way of examples with reference to the accompanying drawings, however, since the above-described embodiments are only described as preferred examples of the present disclosure, the present disclosure should not be understood as being limited to the above embodiments, and the scope of rights of the present disclosure should be understood in terms of the claims described below and their equivalent concepts.

## Claims

1. A light emitting package, comprising:
a substrate on which an circuit pattern is formed;
a first optic portion arranged on the substrate to be electrically connected to the circuit pattern, and generating and emitting light;
a light controller formed to cover a side surface of the first optic portion, and reflecting light emitted from the side surface of the first optic portion; and
a second optic portion covering the first optic portion and the light controller, secured on the light controller, wherein:
the second optic portion includes a securing region secured on the substrate and a light emitting region disposed over the securing region,
light emitted from the first optic portion is emitted to the outside of the second optic portion through the second optic portion, and
the light controller is formed such that at least a region of a bottom edge thereof is disposed inside a region below the light emitting region of the second optic portion.

2. The light emitting package of claim 1,
the first optic portion, comprising:
a light generator that generates light and emits first light from at least a side surface or an upper surface thereof;
an optical characteristic converter formed over the light generator, and emitting the first light and second light from a side surface and an upper surface thereof; and
a connection pad formed under the light generator, and connected to the circuit pattern of the substrate,
wherein the optical characteristic converter converts optical characteristics of some of the first light into optical characteristics of the second light.

3. The light emitting package of claim 2,
wherein the optical characteristic converter converts a wavelength band of some of the first light into a wavelength band of the second light.

4. The light emitting package of claim 2,
wherein the light generator includes a first semiconductor layer doped with an n-type dopant, a second semiconductor layer doped with a p-type dopant, and an active layer formed between the first semiconductor layer and the second semiconductor layer.

5. The light emitting package of claim 4,
wherein the light generator further includes a growth substrate on which the first semiconductor layer or the second semiconductor layer is grown, and arranged under the optical characteristic converter.

6. The light emitting package of claim 1,
wherein the bottom edge of the light controller has a structure in which a first edge and a second edge having different curvatures are alternately arranged in a clockwise or counterclockwise direction.

7. The light emitting package of claim 1,
wherein a corner of the bottom edge of the light controller has a curved shape.

8. The light emitting package of claim 2, further comprising:
a separation layer formed under the optical characteristic converter,
wherein the separation layer is formed along a side surface of the light generator between the light generator and the light controller, and is formed to cover at least a region of the side surface of the light generator.

9. The light emitting package of claim 8,
wherein the first light emitted from the side surface of the light generator is reflected on an inner surface of the light controller through the separation layer, and first light reflected from the inner surface of the light controller is incident on the optical characteristic converter disposed over the separation layer.

10. The light emitting package of claim 8,
wherein the separation layer is formed to cover entire side surfaces of the light generator.

11. The light emitting package of claim 8,
wherein the separation layer is formed such that a bottom thereof is disposed at a midpoint between a top and a bottom of the light generator or under the midpoint.

12. The light emitting package of claim 8,
wherein the separation layer is formed such that a thickness thereof at the side surface of the light generator gradually decreases from the top to the bottom of the light generator.

13. The light emitting package of claim 8,
wherein the separation layer is formed such that the thickness thereof at the side surface of the light generator gradually increases from the top to the bottom of the light generator.

14. The light emitting package of claim 1,
wherein the light emitting region has a structure in which a height of the light emitting region is larger than a bottom diameter of the light emitting region.

15. The light emitting package of claim 1,
wherein at least a region of the securing region is in contact with an upper surface of the substrate.

16. The light emitting package of claim 2, wherein:
the first optic portion includes a plurality of light generators arranged to be spaced apart from one another, and
the optical characteristic converter is formed to cover the plurality of light generators.

17. The light emitting package of claim 2, wherein:
the first optic portion is provided in plurality,
the plurality of first optic portions is arranged to be spaced apart from one another, and
the light controller is formed between the plurality of first optic portions.

18. The light emitting package of claim 1,
wherein the light controller includes a silicone resin and titanium oxide (TiO2) dispersed in the silicone resin.

19. The light emitting package of claim 8,
wherein the separation layer is formed of a silicone resin through which light transmits.

20. The light emitting package of claim 2, wherein:
the substrate further includes a heat dissipation pad formed on a surface opposite to one surface of the substrate on which the first optic portion is disposed,
the heat dissipation pad is disposed under the first optic portion and the circuit pattern formed on one surface of the substrate, and
both ends of the heat dissipation pad, both ends of the connection pad, and both ends of the circuit pattern formed on one surface of the substrate are arranged on different positions from one another with respect to a perpendicular line.
